(19) Europäisches Patentamt / European Patent Office / Office européen des brevets

(11) **EP 2 910 582 B1**

(12) **EUROPEAN PATENT SPECIFICATION**

(45) Date of publication and mention
of the grant of the patent:
**09.01.2019 Bulletin 2019/02**

(21) Application number: **13847646.0**

(22) Date of filing: **17.10.2013**

(51) Int Cl.:
$C08F\ 220/18$ (2006.01)    $B32B\ 27/30$ (2006.01)
$C08F\ 120/10$ (2006.01)    $C08J\ 5/18$ (2006.01)
$C08L\ 33/10$ (2006.01)    $C08L\ 33/14$ (2006.01)
$H01L\ 31/042$ (2014.01)    $B32B\ 27/08$ (2006.01)
$C08F\ 265/06$ (2006.01)    $C09D\ 151/04$ (2006.01)
$C08L\ 51/04$ (2006.01)    $C08F\ 220/10$ (2006.01)
$H01L\ 31/048$ (2014.01)

(86) International application number:
**PCT/JP2013/078208**

(87) International publication number:
**WO 2014/061744 (24.04.2014 Gazette 2014/17)**

(54) **ACRYLIC RESIN FILM, AND LAMINATE AND SOLAR CELL MODULE EACH OF WHICH USES SAME**

ACRYLHARZFILM SOWIE LAMINAT UND SOLARZELLENMODUL DAMIT

FILM DE RÉSINE ACRYLIQUE, ET STRATIFIÉ ET MODULE PHOTOVOLTAÏQUE L'UTILISANT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **17.10.2012 JP 2012230033**

(43) Date of publication of application:
**26.08.2015 Bulletin 2015/35**

(73) Proprietor: **Mitsubishi Chemical Corporation
Tokyo 100-8251 (JP)**

(72) Inventors:
• **KAWAGUCHI, Yuji
Otake-shi
Hiroshima 739-0693 (JP)**
• **KONOKAWA, Yuhei
Otake-shi
Hiroshima 739-0693 (JP)**

(74) Representative: **Ter Meer Steinmeister & Partner
Patentanwälte mbB
Nymphenburger Straße 4
80335 München (DE)**

(56) References cited:
EP-A2- 1 065 731    WO-A1-2012/066848
JP-A- H05 213 663    JP-A- H05 238 808
JP-A- H10 167 836    JP-A- 2004 217 686
JP-A- 2007 066 874    JP-A- 2009 091 540
US-A1- 2008 017 241

EP 2 910 582 B1

**Description**

TECHNICAL FIELD

The present invention relates to an acrylic resin film, which exhibits excellent adhesion to a polyolefin-based resin, thereby providing a laminate thereof. In addition, the acrylic resin film may be used as a surface protective material of a solar cell module, thereby providing a solar cell module using the same.

BACKGROUND ART

Recently, in accordance with the uplift of environmental awareness, the shift of the generation method, that is, a thermal power generation that depends upon fossil fuel, a limited resource, is shifted into the generation of a solar energy, a clean energy, is proceeding. Therefore, recently, several categories of solar cell modules are being developed.

As a surface protective material used for these solar cell modules, a glass plate is generally used. However, for a glass plate used for them, the thickness of about several mm is required in order to maintain the strength as a protective material. In order to supply electric power that is necessary for a general home using a solar cell module, the area of 20 m$^2$ or more is required, and thus, in some cases, the weight of glass plate is 100 kg or more. In addition, when a general home uses a solar cell module, the solar cell module is generally installed on a roof so as to effectively use the light of the sun. Therefore, there is a problem in that, when the weight material is installed on a roof, the construction for reinforcing the structure of a house is required, thereby causing increase of installation cost. In addition, there is a problem in that, since the glass has poor flexibility, as a usage for a thin film solar cell requiring flexibility, the usage thereof is limited.

As a method for solving this problem, the method using a film has been reviewed. Above all, the method using an acrylic resin film or a film including an acrylic resin, which exhibits excellent light transmittance, has been reviewed (Patent Document 1). However, for example, when the acrylic resin film disclosed in Patent Document 1 is used, there are problems in that the adhesion to an encapsulant of a solar cell including ethylene-vinyl acetate copolymer film (hereinafter, referred to as EVA) of a polyolefin-based resin as a main component is not good, and a film is easily peeled off. In addition, in order to manifest adhesion, a layer having adhesion to a film (hereinafter, referred to as an adhesive layer) may be provided, but it is not preferable in terms of the increase of processes for providing an adhesive layer or the load on environment.

WO 2012/066848 A1 relates to a flexible solar cell module comprising a solar cell element and a solar cell encapsulant which are adhered to each other without causing wrinkles and curls, wherein the solar cell encapsulant comprises a fluoropolymer sheet and an adhesive layer on the fluoropolymer sheet.

US 2008/017241 A1 relates to a thermoplastic film or sheet having a thickness of 0.26 mm to 0.51 mm containing a surface embossed layer comprising a copolymer of alpha olefins with alpha, beta ethylenically unsaturated carboxylic acid comonomers, ionomers derived therefrom and combinations thereof.

EP 1 065 731 relates to a solar cell module in form of a laminate comprising a PET film.

CITATION LIST

PATENT DOCUMENT

Patent Document 1: JP 2004-227843 A

DISCLOSURE OF THE INVENTION

PROBLEM TO BE SOLVED BY THE INVENTION

In order to improve the increase of the processes or the load on environment, it is expected that the adhesion to a polyolefin-based resin is manifested without using a solvent, and also, a film having excellent flexibility and light transmittance that are required for a surface protective material of a thin film solar cell is developed.

An object of the invention is to provide an acrylic resin film having excellent flexibility and light transmittance, and also excellent adhesion to a polyolefin-based resin, and a solar cell module using the film.

MEANS FOR SOLVING PROBLEM

The present invention relates to an acrylic resin film comprising a polymer (A) that is obtained by polymerizing a monomer component including i-butyl methacrylate as specified in claim 1. Preferred embodiments of the acrylic resin film are as defined in the dependent claims.

Another aspect of the invention relates to a laminated molded body having at least two layers, which are laminated with the acrylic resin film as described herein, and a thermoplastic resin sheet and/or a thermosetting resin sheet.

Another aspect of the invention relates to a solar cell module using the acrylic resin film described herein.

Another aspect of the invention relates to a polymer, the polymer being a rubber-containing polymer obtained by polymerizing a monomer component including 10 to 100% by mass of i-butyl methacrylate in the presence of an acrylic-based rubber polymer (A2a), and also, satisfying the following contents.

- The ratio of an acrylic-based rubber polymer (A2a) is 15 to 60% by mass.
- The ratio of a polymer (A2b) obtained by polymerizing a monomer component including 10 to 100% by mass of i-butyl methacrylate is 85 to 40% by mass (under the condition that the total amount of A2a and A2b is 100% by mass).

Another aspect of the invention relates to the polymer described above, in which the acrylic-based rubber polymer (A2a) is obtained by polymerizing a monomer component described below.

<Monomer component>

1. 40 to 99.9% by mass of alkyl acrylate
2. 0 to 59.9% by mass of alkyl methacrylate
3. 0 to 49.9% by mass of other monomers having a double bond capable of being copolymerized with alkyl acrylate and/or alkyl methacrylate
4. 0.1 to 10% by mass of multifunctional monomer having two or more double bonds in one molecule, which are capable of being copolymerized with the monomers disclosed in 1 to 3
5. 50 to 99.9% by mass of the total amount of alkyl acrylate and alkyl methacrylate, and wherein the total amount of the above 1 to 4 is 100% by mass

EFFECT OF THE INVENTION

According to the invention, it is possible to provide an acrylic resin film having excellent flexibility and light transmittance, and also, excellent adhesion to a polyolefin-based resin, a laminate thereof, and a solar cell module using the film.

MODE(S) FOR CARRYING OUT THE INVENTION

<Polymer (A)>

The polymer (A) is a polymer obtained by polymerizing a monomer component including i-butyl methacrylate, wherein the polymer (A) is a rubber-containing polymer (A2).

<Thermoplastic polymer (A1)> (Reference polymer)

The thermoplastic polymer (A1) is a thermoplastic polymer obtained by polymerizing a monomer component including i-butyl methacrylate (the total amount of i-butyl methacrylate and other monomers is 100% by mass).

In addition, in the present specification, "(meth)acrylic" refers to "acrylic" or "methacrylic."

The content of i-butyl methacrylate in the monomer component that forms the thermoplastic polymer (A1) is preferably 10 to 100% by mass. By being the content of i-butyl methacrylate to be 10 to 100% by mass, the adhesion of the acrylic resin film including the thermoplastic polymer obtained by polymerizing the monomer component to a polyolefin-based resin becomes good. When the content thereof is 10% by mass or more, it is possible to manifest the adhesion to a polyolefin-based resin, and the content is more preferably 20% by mass or more, still more preferably 30% by mass or more, and most preferably 40% by mass or more. As the amount of i-butyl methacrylate in the monomer that forms the thermoplastic polymer (A1) is high, sufficient adhesion may be manifested even though the content of the thermoplastic polymer (A1) in the the acrylic resin composition described later is low. In addition, the content of i-butyl methacrylate in the thermoplastic polymer (A1) may be also 100% by mass.

As the monomer components other than i-butyl methacrylate in the monomer that forms the thermoplastic polymer (A1), any monomers may be used as long as the monomers have a double bond capable of copolymerizing with i-butyl methacrylate.

Examples of other monomers having a double bond capable of being copolymerized may include an alkyl acrylate having a linear or branched alkyl group, and specific examples thereof may include methyl acrylate, ethyl acrylate, propyl acrylate, n-butyl acrylate, 2-ethylhexyl acrylate, and n-octyl acrylate. There may be an alkyl methacrylate having a linear or branched alkyl group, and may be methyl methacrylate, ethyl methacrylate, propyl methacrylate, and n-butyl methacrylate. Examples of other monomers having a double bond capable of being copolymerized may include (meth)acrylic-based monomers, such as, acrylic lower alkoxy, cyanoethyl acrylate, acrylic amide, and (meth)acrylate; aromatic vinyl monomers, such as, styrene and alkyl-substituted styrene; and vinyl cyanide monomers, such as, acrylonitrile and methacrylonitrile. These monomers having a double bond capable of copolymerizing with i-butyl methacrylate may be used singly or in combination of two or more thereof.

A chain transfer agent may be included in the monomer component that forms the thermoplastic polymer (A1). The chain transfer agent is preferably 0 to 5% by mass with respect to the total amount of the monomer component.

Examples of the chain transfer agent may include alkylmercaptan having 2 to 20 carbon atoms, mercapto acids, thiophenol, and carbon tetrachloride. They may be used singly or in combination of two or more thereof. Examples thereof may include n-octyl mercaptan.

Examples of the method of polymerizing a thermoplastic polymer (A1) may include a suspension polymerization method, an emulsification polymerization method, and an agglomerated polymerization method. Among them, the suspension polymerization method and emulsification polymerization method are preferable, because it is easy to deal with a thermoplastic polymer.

As a polymerization initiator that is used for polymerizing a monomer component in order to obtain a thermoplastic polymer (A1), the known polymerization initiators may be used. Examples of the polymerization initiator may include peroxide, an azo-based initiator, and a redox-based initiator prepared by mixing peroxide or an azo-based initiator with an oxidizing agent a reducing agent. They may be used singly or in combination of two or more thereof.

Specific examples of a redox-based initiator may include a sulfoxylate-based initiator prepared by combining ferrous sulfate, disodium ethylenediaminetetraacetate, rongalite, and hydroperoxide. As hydroperoxide, there may be specifically cumene hydroperoxide and t-butyl hydroperoxide.

As a molecular weight of a thermoplastic polymer (A1), a mass average molecular weight thereof is preferably 20,000 to 10,000,000, more preferably 50,000 to 7,000,000, still more preferably 80,000 to 5,000,000, and most preferably 100,000 to 3,000,000.

When the mass average molecular weight of the thermoplastic polymer (A1) is 20,000 or more, it is possible to obtain sufficient adhesion between the acrylic resin film including the thermoplastic polymer (A1) and an encapsulant. When it is 10,000,000 or less, the compatibilities with a rubber-containing polymer (A2), an acrylic-based rubber-containing polymer (B), and a thermoplastic polymer (C) described below are excellent, and thus, optical properties become good. Therefore, the above range is preferable.

The content of the thermoplastic polymer (A1) in an acrylic resin film is not particularly limited, but the content of the thermoplastic polymer (A1) is preferably 0.3 to 90% by mass, more preferably 0.5 to 75% by mass, still more preferably 1 to 60% by mass, and most preferably 1 to 50% by mass in 100% by mass of the acrylic resin that constitutes an acrylic resin film (the total amount of the thermoplastic polymer (A1), and a rubber-containing polymer (A2), an acrylic-based rubber-containing polymer (B), and a thermoplastic polymer (C) described below is 100% by mass).

By being the content of the thermoplastic polymer (A1) in the resin composition that constitutes the acrylic resin film to be 0.3% by mass or more, it is possible to manifest the adhesion between the obtained acrylic resin film and a polyolefin-based resin.

In addition, by being the content thereof to be 90% by mass or less, it is possible to obtain the acrylic resin film having both of adhesion and flexibility.

<Rubber-containing polymer (A2)>

The rubber-containing polymer (A2) is a rubber-containing polymer including a polymer obtained by polymerizing a monomer component including i-butyl methacrylate.

The polymer that forms the rubber-containing polymer (A2) includes a polymer obtained by polymerizing a monomer component including 10 to 100% by mass of i-butyl methacrylate. By including the rubber-containing polymer (A2), the adhesion of the acrylic resin film to a polyolefin-based resin becomes good, and thus, it is preferable. When the content of i-butyl methacrylate in the monomer component that forms the rubber-containing polymer (A2) is 10% by mass or more, it is possible to manifest the adhesion to a polyolefin-based resin, and the content thereof is more preferably 15% by mass or more, still more preferably 20% by mass or more, and most preferably 25% by mass or more. In addition, the content of i-butyl methacrylate in the monomer component that forms the rubber-containing polymer (A2) may be also 100% by mass.

As the amount of i-butyl methacrylate in the monomer component that forms the rubber-containing polymer (A2) is high, the sufficient adhesion to a polyolefin-based resin may be manifested.

The monomer components other than i-butyl methacrylate in the monomer components that form the rubber-containing polymer (A2) may be the examples disclosed in the description on the thermoplastic polymer (A1). They may be used singly or in combination of two or more thereof.

In the invention, the rubber-containing polymer (A2) is a polymer including an acrylic-based rubber polymer (A2a) obtained by polymerizing the monomer component (A2-a) including at least alkyl acrylate and multifunctional monomer.

In addition, it may be also a rubber-containing polymer obtained by polymerizing the monomer component (A2-b) including alkyl methacrylate in the presence of the acrylic-based rubber polymer (A2a).

In this case, i-butyl methacrylate may include one or both of the acrylic-based rubber polymer (A2a), and the polymer (A2b) other than the acrylic-based rubber polymer obtained by polymerizing the monomer component (A2-b) including alkyl methacrylate.

The content of the rubber-containing polymer (A2) in the acrylic resin film is not particularly limited, but the content of the rubber-containing polymer (A2) is preferably 20 to 100% by mass, more preferably 25 to 90% by mass, still more preferably 30 to 85% by mass, and most preferably 35 to 80% by mass in 100% by mass of the acrylic resin that constitutes the acrylic resin film (the total amount of the thermoplastic polymer (A1), the rubber-containing polymer (A2), and an acrylic-based rubber-containing polymer (B) and a thermoplastic polymer (C) described below is 100% by mass).

By being the content of the rubber-containing polymer (A2) to be 20% by mass or more in 100% by mass of the acrylic resin that constitutes the acrylic resin film, it is possible to manifest the adhesion between the obtained acrylic resin film and a polyolefin-based resin.

In addition, in terms of the flexibility of the acrylic resin film, the rubber-containing polymer (A2) may be only used.

In the present invention, the rubber-containing polymer includes 15 to 60% by mass of an acrylic-based rubber polymer (A2a) and 85 to 40% by mass of the polymer (A2b) other than the acrylic-based rubber polymer (under the condition that the total amount of A2a and A2b is 100% by mass). More preferably, the acrylic-based rubber polymer (A2a) is 20 to 55% by mass and the polymer (A2b) other than the acrylic-based rubber polymer is 80 to 45% by mass. Still more preferably, the acrylic-based rubber polymer (A2a) is 25 to 45% by mass and the polymer (A2b) other than the acrylic-based rubber polymer is 75 to 55% by mass.

By being the acrylic-based rubber polymer (A2a) to be 15% by mass or more, it is possible to impart flexibility to the acrylic resin film, and thus, it is preferable. In addition, by being it to be 60% by mass or less, it is possible to make the acrylic resin film that is formed only with the rubber-containing polymer (A2) to be a thin film.

<<Acrylic-based rubber polymer (A2a)>>

The acrylic-based rubber polymer (A2a) is a polymer obtained by polymerizing a monomer component (A2-a) described below. The monomer component (A2-a) includes alkyl acrylate and a multifunctional monomer as an essential component.

In the monomer component (A2-a) that constitutes the acrylic-based rubber polymer (A2a), there may be an alkyl acrylate having a linear or branched alkyl group, and specific examples thereof may include methyl acrylate, ethyl acrylate, propyl acrylate, n-butyl acrylate, 2-ethylhexyl acrylate, and n-octyl acrylate. They may be used singly or in combination of two or more thereof.

As a multifunctional monomer among the monomer component (A2-a) that constitutes the acrylic-based rubber polymer (A2a), there may be a crosslinkable monomer having two or more copolymerizable double bonds in one molecule. The multifunctional monomer may be alkylene glycol dimethacrylate, such as, ethylene glycol di(meth)acrylate, di(meth)acrylate 1,3-butylene glycol, di(meth)acrylate 1,4-butylene glycol, and propylene glycol dimethacrylate; polyvinylbenzene, such as, divinylbenzene and trivinylbenzene; and cyanurate-based monomers, such as, triallyl cyanurate and triallyl isocyanurate, $\alpha,\beta$-unsaturated carboxylic acid, such as, allyl methacrylate, allyl, methallyl, or crotyl ester of dicarboxylic acid, or the like. They may be used singly or in combination of two or more thereof.

The monomers other than alkyl acrylate and multifunctional monomer may be included in the monomer component (A2-a) that constitutes the acrylic-based rubber polymer (A2a). Examples of the monomers may include alkyl methacrylate, and other monomers having a double bond capable of being copolymerized the alkyl methacrylate.

As alkyl methacrylate, there may be the alkyl methacrylate having a linear or branched alkyl group, and may be methyl methacrylate, ethyl methacrylate, propyl methacrylate, and n-butyl methacrylate. Examples of other monomers having a copolymerizable double bond may include (meth)acrylic-based monomers, such as, acrylic lower alkoxy, cyanoethyl acrylate, acrylic amide, and (meth)acrylate; aromatic vinyl monomers, such as, styrene and alkyl-substituted styrene; and vinyl cyanide monomers, such as, acrylonitrile, and methacrylonitrile. They may be used singly or in combination of two or more thereof.

The monomer component (A2-a) that constitutes the acrylic-based rubber polymer (A2a) may include a chain transfer agent.

As the chain transfer agent, the examples disclosed in the description on the thermoplastic polymer (A1) may be used. They may be used singly or in combination of two or more thereof.

The content of alkyl acrylate in the monomer component (A2-a) that constitutes the acrylic-based rubber polymer (A2a) is 40 to 99.9% by mass.

The content of alkyl methacrylate in the monomer component (A2-a) is 0 to 59.9% by mass.

In addition, in the monomer component (A2a) that constitutes the acrylic-based rubber polymer (A2a), the total amount of the contents of alkyl acrylate and alkyl methacrylate is 50 to 99.9% by mass and more preferably 60 to 99.9% by mass.

In the monomer component (A2-a) that constitutes the acrylic-based rubber polymer (A2a), the content of other monomers having a double bond capable of being copolymerized with the monomer component is 0 to 49.9% by mass.

In the monomer component (A2-a) that constitutes the acrylic-based rubber polymer (A2a), the content of multifunctional monomer is 0.1 to 10% by mass.

The glass transition temperature (hereinafter, referred to as Tg) of the acrylic-based rubber polymer (A2a) is preferably 10°C or lower, and more preferably 0°C or lower in terms of the flexibility of the rubber-containing polymer (A2). The Tg of the acrylic-based rubber polymer (A2a) is preferably -100°C or higher, and more preferably -80°C or higher.

Furthermore, in the invention, Tg refers to a value calculated from Equation of FOX using the values disclosed in Polymer HandBook (J. Brandrup, Interscience, 1989).

In addition, the acrylic-based rubber polymer (A2a) may be polymerized by using two or more divided steps. At this time, the monomer components for the respective steps may be the same or different from each other.

Furthermore, "other composition" related to a polymer refers that at least one of the type and content of the monomer that forms a polymer is different.

<<Polymer (A2b)>>

The polymer (A2b) is a polymer (under the condition that a part of the acrylic-based rubber polymer (A2a) is not provided) obtained by polymerizing a monomer component (A2-b) including alkyl methacrylate in the presence of the acrylic-based rubber polymer (A2a).

The monomer component (A2-b) that constitutes a polymer (A2b) may include alkyl acrylate, other monomers having a double bond capable of being copolymerized with the alkyl arcylate, and arbitrarily, a multifunctional monomer, other than alkyl methacrylate including i-butyl methacrylate. In addition, the monomer component (A2-b) that constitutes a polymer (A2b) may include a chain transfer agent. In detail, the examples disclosed in the description on the thermoplastic polymer (A1) and acrylic-based rubber polymer (A2a) may be used. They may be used singly or in combination of two or more thereof.

In the monomer component (A2-b) that constitutes a polymer (A2b), the content of alkyl methacrylate is preferably 9.9 to 100% by mass, more preferably 50 to 100% by mass, and still more preferably 70 to 99% by mass.

In the monomer component (A2-b) that constitutes a polymer (A2b), the content of alkyl acrylate is preferably 0 to 90% by mass.

In the monomer component (A2-b) that constitutes a polymer (A2b), the content of other monomers having a double bond capable of being copolymerized with them is preferably 0 to 49% by mass.

In the monomer component (A2-b) that constitutes a polymer (A2b), the content of multifunctional monomer is 0 to 10% by mass.

The content of a polymer (A2b) ((Polymer (A2a) + Polymer (A2b)) = 100% by mass) is preferably 40 to 85% by mass, more preferably 45 to 80% by mass, and still more preferably 50 to 75% by mass, in terms of a film-forming property, molding whitening resistance, thermal resistance, and flexibility.

By being the content thereof to be 40% by mass or more, it is possible to make an acrylic resin film to be a thin film. By being the content thereof to be 85% by mass or less, it is possible to impart flexibility to an acrylic resin film.

In addition, the polymer (A2b) may be polymerized by using two or more divided steps. At this time, the monomer components for the respective steps may be the same or different from each other.

When the polymer (A2b) is polymerized by using two or more divided steps, the monomer component (A2-b-1) that is first used is preferably a monomer component including 9.9 to 90% by mass of alkyl acrylate, 9.9 to 90% by mass of alkyl methacrylate, 0 to 20% by mass of other monomers having a double bond capable of being polymerized with them, and 0.1 to 10% by mass of a multifunctional monomer, in terms of the molding whitening resistance of an acrylic resin film to be obtained.

The Tg of the polymer (A2b1) obtained by polymerizing the monomer component (A2-b-1) that is first used is preferably higher than the Tg of the acrylic-based rubber polymer (A2a) in terms of the molding whitening resistance of an acrylic resin film.

When the polymer (A2b) is polymerized by using two or more divided steps, a monomer component (A2-b-y) that is used for a final y step includes preferably 51 to 100% by mass of alkyl methacrylate, 0 to 20% by mass of alkyl acrylate, and 0 to 49% by mass of other monomers having a double bond capable of being copolymerized with them, in terms of the thermal resistance of an acrylic resin film.

The content of the polymer (A2b1) in the polymer (A2b) is preferably 5 to 50% by mass, more preferably 7.5 to 40% by mass, and still more preferably 10 to 30% by mass with respect to 100% by mass of the polymer (A2b), in terms of the molding whitening resistance.

<Method of preparing rubber-containing polymer (A2)>

As a method of preparing a rubber-containing polymer (A2), there may be, for example, a sequentially multistep emulsification polymerization method, and an emulsification suspension polymerization method including converting an emulsification polymerization system into a suspension polymerization system at the time of being polymerized when more monomer component (A2-b) is polymerized after performing a sequentially multistep emulsification polymerization of a monomer component (A2-b), if necessary, in the presence of an acrylic rubber polymer (A2a).

Examples of the method of preparing a rubber-containing polymer (A2) by using the sequentially multistep emulsification polymerization method may include a polymerization method including supplying the emulsion prepared by mixing a monomer component (A2-a), water, and a surfactant for obtaining an acrylic-based rubber polymer (A2a) into a reactor for the polymerization, and then, supplying a monomer component (A2-b) into the reactor in order for the polymerization.

The acrylic resin film obtained by using a rubber-containing polymer (A2) that may be obtained by using the above-described method is preferable in terms of the property of low number of fish eyes in the film.

Examples of the surfactant that is used when the rubber-containing polymer (A2) is prepared by using a sequentially multistep emulsification polymerization method may be an anionic-based, a cationic-based and nonionic-based surfactant. They may be used singly or in combination of two or more thereof.

The anionic-based surfactant may be carboxylate, such as, rosin soap, potassium oleate, sodium stearate, sodium myristate, sodium N-laurylsarcosinate, and dipotassium alkenylsuccinate; sulfate, such as, sodium lauryl sulfate; sulfonate, such as, sodium dioctylsulfosuccinate, sodium dodecylbenzenesulfonate, and sodium alkyldiphenyl etherdisulfonate; and phosphate, such as, sodium polyoxyethylene alkylphenyl ether phosphate and sodium polyoxyethylene alkyl ether phosphate.

The specific examples of the commercially available anionic-based surfactant may include ELEMINOL NC-718 prepared by Sanyo Chemical Industries, Ltd., PHOSPHANOL LS-529, PHOSPHANOL RS-610NA, PHOSPHANOL RS-620NA, PHOSPHANOL RS-630NA, PHOSPHANOL RS-640NA, PHOSPHANOL RS-650NA, and PHOSPHANOL RS-660NA, which are prepared by TOHO Chemical Industry Co., Ltd., and LATEMUL P-0404, LATEMUL P-0405, LATEMUL P-0406, and LATEMUL P-0407, which are prepared by Kao Corporation (all the above names are trade names).

As a method of preparing an emulsion by mixing a monomer component (A2-a), water, and a surfactant, for example, there may be a method of adding a surfactant after adding a monomer component (A2-a) to water; a method of adding a monomer component (A2-a) after a surfactant to water; and a method of adding water after a surfactant to a monomer component (A2-a).

As a mixing device of preparing an emulsion by mixing a monomer component (A2-a) with water and a surfactant, for example, there may be a stirrer including a stirring wing; a forced emulsifying device, such as, a homogenizer and a homomixer; and a film emulsifying device.

As the emulsion, any dispersion among a W/O type having water drops dispersed in the oil of a monomer component (A2-a) and an O/W type having the oil drops of a monomer component (A2-a) dispersed in water may be used.

Furthermore, examples of a method of polymerizing an acrylic-based rubber polymer (A2a) may include a method of integrally polymerizing the monomer component (A2-a), and a method of polymerizing in the multi-steps after dividing the monomer component (A2-a) into two or more parts. For the monomer component (A2-a) in the case of polymerizing in the multi-steps, the monomer component having the same components may be polymerized in the multi-steps or the monomer component having other components may be polymerized in the multi-steps.

The latex of the rubber-containing polymer (A2) obtained by the above method may be treated by using a filtering device having an arranged filter medium, if necessary. The filtering treatment is used to remove scales generated during the polymerization from the latex of the rubber-containing polymer (A2) or to remove contaminant incorporated from outside in the polymerizing raw materials or during the polymerization.

Examples of the filtering device having an arranged filter medium may include GAF filter system using a pouched mesh filter, manufactured by ISP filters PTE Limited, a centrifuged filtering device having a cylindrical filter medium in the inside surface of a cylindrical filter room and a stirring wing in the filter medium, and a vibration filtering device that performs a circular movement that is horizontal to the filter medium and an amplitude movement that is vertical to the filter medium.

The rubber-containing polymer (A2) may be obtained in a powder material by collecting from the latex of the rubber-containing polymer (A2).

Examples of a method of collecting the rubber-containing polymer (A2) from the latex of the rubber-containing polymer (A2) may include a solidification method by a salt precipitation or an acid precipitation, a spray-drying method, and a freeze-drying method.

When the rubber-containing polymer (A2) is collected by a solidification method by a salt precipitation using a metal salt, the content of remaining metal in the rubber-containing polymer (A2) finally obtained is preferably 800 ppm or less, and as the content of remaining metal is very small, it is preferable.

When as the metal salt for the salt precipitation treatment, calcium, magnesium, and sodium that have strong affinity to water, preferably, calcium salts are used, the content of remaining metal in the rubber-containing polymer (A2) is to be as little as possible, and thus, the whitening phenomenon generated when the acrylic resin film is dipped in boiling water may be easily inhibited.

As a polymerization initiator used when polymerizing a monomer component (A2-a) and a monomer component (A2-b) in the rubber-containing polymer (A2), the known initiators may be used, and the examples disclosed in the description on the thermoplastic polymer (A1) may be used. They may be used singly or in combination of two or more thereof.

When as a method of preparing the latex of a rubber-containing polymer (A2), it is prepared by a polymerization method including supplying the monomer component (A2-b) in order into a reactor after performing the polymerization by supplying an emulsion prepared by mixing a monomer component (A2-a) with water and a surfactant into the reactor, it is preferable that after increasing the temperature of aqueous solution in the polymerization vessel including ferrous sulfate, disodium ethylenediaminetetraacetate, and Rongalite to a polymerization temperature, the emulsion prepared by mixing the monomer component (A2-a) with water and a surfactant be supplied to the reactor and then is polymerized, and then, sequentially, the monomer component (A2-b) be supplied into the reactor and then be polymerized.

Examples of the polymerization temperature for obtaining the latex of the rubber-containing polymer (A2) may be 40 to 120°C, but depends on a type or amount of the polymerization initiator used.

<Acrylic-based rubber-containing polymer (B)>

The acrylic resin that constitutes the acrylic resin film and the film of the invention may further include an acrylic-based rubber-containing polymer (B) that is a rubber-containing polymer other than the rubber-containing polymer (A2). The acrylic-based rubber-containing polymer (B) is different from the rubber polymer (A2) because it does not include i-butyl methacrylate in a polymer.

By including the acrylic-based rubber-containing polymer (B), when the acrylic resin composition is molded in a pellet phase, it is possible to impart the acrylic resin handling property or the described flexibility to the obtained acrylic resin film.

In the invention, an acrylic-based rubber-containing polymer (B) is a rubber-containing polymer obtained by polymerizing a monomer component (B-b) including at least alkyl methacrylate in the presence of the acrylic-based rubber polymer (Ba) obtained by polymerizing a monomer component (B-a) including at least alkyl acrylate and a multifunctional monomer.

<<Acrylic-based rubber polymer (Ba)>>

The examples disclosed in the description on the thermoplastic polymer (A1) may be used as alkyl acrylate in the monomer component (B-a) that constitutes the acrylic-based rubber polymer (Ba). They may be used singly or in combination of two or more thereof.

As the multifunctional monomer in the monomer component (B-a) that constitutes the acrylic-based rubber polymer (Ba), the examples disclosed in the description on the acrylic-based rubber polymer (A2a) may be used. They may be used singly or in combination of two or more thereof.

The monomer component (B-a) that constitutes an acrylic-based rubber polymer (Ba) may include the monomers other than alkyl acrylate and multifunctional monomer, and examples of these monomers may include alkyl methacrylate, and other monomers having a double bond capable of being copolymerized with the alkyl methacrylate.

As alkyl methacrylate and other monomers having a copolymerizable double bond, the examples disclosed in the description on the acrylic-based rubber polymer (A2a) may be used. They may be used singly or in combination of two or more thereof.

The monomer component (B-a) that constitutes an acrylic-based rubber polymer (Ba) may include a chain transfer agent.

As the chain transfer agent, the examples disclosed in the description on the thermoplastic polymer (A1) may be used. They may be used singly or in combination of two or more thereof.

The content of alkyl acrylate in a monomer component (B-a) is preferably 40 to 99.9% by mass.

The content of alkyl methacrylate in the monomer component (B-a) is preferably 0 to 59.9% by mass.

In addition, the total amount of the contents of alkyl acrylate and alkyl methacrylate in the monomer component (B-a) is preferably 50 to 99.9% by mass and more preferably 60 to 99.9% by mass.

The content of other monomers having a double bond capable of being copolymerized with them in the monomer component (B-a) is preferably 0 to 30% by mass.

The content of a multifunctional monomer in a monomer component (B-a) is preferably 0.1 to 10% by mass.

The glass transition temperature (hereinafter, referred to as Tg) of an acrylic-based rubber polymer (Ba) is preferably lower than 25°C, more preferably 10°C or lower, and still more preferably 0°C or lower, in terms of the flexibility of an acrylic-based rubber-containing polymer (B). The Tg of the acrylic-based rubber polymer (Ba) is preferably -100°C or higher, and more preferably -80°C or higher. Furthermore, in the invention, the Tg refers to the value calculated from a FOX equation using the value disclosed in Polymer HandBook (J. Brandrup, Interscience, 1989).

The content of a monomer component (B-a) ((Monomer component (B-a) + Monomer component (B-b) + Monomer component (B-c)) = 100% by mass) in the acrylic-based rubber-containing polymer (B) is preferably 5 to 80% by mass and more preferably 20 to 70% by mass, in terms of a film-forming property, molding whitening resistance, thermal resistance, and flexibility.

<<Polymer (Bb)>>

The acrylic-based rubber-containing polymer (B) is an acrylic-based rubber-containing polymer including a polymer (Bb) obtained by polymerizing a monomer component (B-b) including alkyl methacrylate as a main component in the presence of an acrylic-based rubber polymer (Ba).

The monomer component (B-b) may include alkyl acrylate other than alkyl methacrylate and other monomers having a double bond capable of being polymerized with the alkyl acrylate. In addition, the monomer component (B-b) may include a chain transfer agent. In detail, the examples disclosed in the description on the thermoplastic polymer (A1) and acrylic-based rubber polymer (A2a) may be used. They may be used singly or in combination of two or more thereof.

The content of alkyl methacrylate in a monomer component (B-b) is preferably 51 to 100% by mass.

The content of alkyl acrylate in the monomer component (B-b) is preferably 0 to 20% by mass.

The content of other monomer having a double bond capable of being polymerized with them in the monomer component (B-b) is preferably 0 to 49% by mass.

The content of the monomer component (B-b) (Monomer component (B-a) + Monomer component (B-b) + Monomer component (B-c) = 100% by mass) is preferably 20 to 95% by mass and more preferably 30 to 80% by mass, in terms of a film-forming property, molding whitening resistance, thermal resistance, and flexibility.

<<Polymer (Bc)>>

Before polymerizing a monomer component (B-b), the monomer component (B-c) including 9.9 to 90% by mass of alkyl acrylate, 9.9 to 90% by mass of alkyl methacrylate, 0 to 20% by mass of other monomer having a double bond capable of being copolymerized with them, and 0.1 to 10% by mass of a multifunctional monomer may be polymerized. In addition, the monomer component (B-c) may include a chain transfer agent. In detail, the examples disclosed in the description on the thermoplastic polymer (A1) may be used. They may be used singly or in combination of two or more thereof.

The Tg of the polymer (Bc) obtained by polymerizing a monomer component (B-c) is preferably higher than the Tg of the acrylic-based rubber polymer (Ba) in terms of the molding whitening resistance of an acrylic resin film.

As the composition of the monomer component (B-c), the composition that is different from the composition of the monomer component (B-a) is preferable. By being the composition of the monomer component (B-a) to be different from the composition of the monomer component (B-c), it is easy to make the molding whitening resistance of the acrylic resin film good.

The Tg of single polymer obtained from a monomer component (B-c) is preferably 0 to 100°C. In terms of thermal resistance and flexibility, the Tg is preferably 0°C or higher. In addition, in terms of a film-forming property and molding whitening resistance, the Tg is preferably 100°C or lower, more preferably 80°C or lower, and still more preferably 70°C or lower.

The content of the monomer component (B-c) (Monomer component (B-a) + Monomer component (B-b) + Monomer component (B-c) = 100% by mass) is preferably 5 to 35% by mass and more preferably 5 to 20% by mass, in terms of a film-forming property, molding whitening resistance, thermal resistance, and flexibility.

When the acrylic-based rubber-containing polymer (B) is used, the content of the acrylic-based rubber-containing polymer (B) in the acrylic resin is not particularly limited, but is preferably 0 to 99.7% by mass, more preferably 20 to 99.5% by mass, still more preferably 40 to 99.0% by mass, and most preferably 60 to 99% by mass in 100% by mass of the acrylic resin that constitutes the acrylic resin film (the total amount of the thermoplastic polymer (A1), rubber-containing polymer (A2), acrylic-based rubber-containing polymer (B), and a thermoplastic polymer (C) described below is 100% by mass).

<Method of preparing acrylic-based rubber-containing polymer (B)>

As a method of preparing an acrylic-based rubber-containing polymer (B), there may be, for example, a sequentially multistep emulsification polymerization method, and an emulsification suspension polymerization method including converting an emulsification polymerization system into a suspension polymerization system at the time of polymerizing a monomer component (B-b) after performing a sequentially multistep emulsification polymerization of a monomer component (B-c) in order, if necessary, in the presence of an acrylic rubber polymer (Ba).

Examples of the method of preparing an acrylic-based rubber-containing polymer (B) with the sequentially multistep emulsification polymerization may include a polymerization method including supplying the emulsion prepared by mixing a monomer component (B-a), water, and a surfactant for obtaining an acrylic-based rubber polymer (Ba) into a reactor for the polymerization, and then, supplying a monomer component (B-c) and a monomer component (B-b) into the reactor in order for the polymerization.

The acrylic resin film obtained by using an acrylic-based rubber-containing polymer (B) that may be obtained by using the above-described method is preferable in terms of the property of low number of fish eyes in the film.

Examples of the surfactant that is used when the acrylic-based rubber-containing polymer (B) is prepared by using a sequentially multistep emulsification polymerization method may be an anionic-based, a cationic-based and nonionic-based surfactant. They may be used singly or in combination of two or more thereof.

As the anionic-based surfactant, the examples disclosed in the description on the method of preparing a rubber-containing polymer (A2) may be used.

As a method of preparing an emulsion by mixing a monomer component (B-a), water, and a surfactant, for example, there may be a method of adding a surfactant after adding a monomer component (B-a) to water; a method of adding a monomer component (B-a) after a surfactant to water; and a method of adding water after a surfactant to a monomer component (B-a).

As a mixing device of preparing an emulsion by mixing a monomer component (B-a) with water and a surfactant, for example, there may be a stirrer including a stirring wing; a forced emulsifying device, such as, a homogenizer and a homomixer; and a film emulsifying device.

As the emulsion, any dispersion among a W/O type having water drops dispersed in the oil of a monomer component (B-a) and an O/W type having the oil drops of a monomer component (B-a) dispersed in water may be used.

Furthermore, examples of a method of polymerizing an acrylic-based rubber polymer (Ba) may include a method of integrally polymerizing the monomer component (B-a), and a method of polymerizing in the multi-steps after dividing the monomer component (B-a) into two or more parts. For the monomer component (B-a) in the case of polymerizing in the multi-steps, the monomer component having the same components may be polymerized in the multi-steps or the monomer component having other components may be polymerized in the multi-steps.

The latex of the acrylic-based rubber-containing polymer (B) obtained by the above method may be treated by using a filtering device having an arranged filter medium, if necessary. As the filtering treatment and filtering device, the examples disclosed in the description on the method of preparing a rubber-containing polymer (A2) may be used.

The acrylic-based rubber-containing polymer (B) may be obtained in a powder material by collecting (collecting by isolating solid and liquid) from the latex of the acrylic-based rubber-containing polymer (B).

Examples of a method of collecting the acrylic-based rubber-containing polymer (B) from the latex of the acrylic-based rubber-containing polymer (B) may include a solidification method by a salt precipitation or an acid precipitation, a spray-drying method, and a freeze-drying method.

When the acrylic-based rubber-containing polymer (B) is collected by a solidification method by a salt precipitation using a metal salt, the content of remaining metal in the acrylic-based rubber-containing polymer (B) finally obtained is preferably 800 ppm or less, and as the content of remaining metal is very small, it is preferable.

When as the metal salt for the salt precipitation treatment, calcium, magnesium, and sodium that have strong affinity to water, preferably, calcium salts are used, the content of remaining metal in the acrylic-based rubber-containing polymer (B) is to be as little as possible, and thus, the whitening phenomenon generated when the acrylic resin film is dipped in boiling water may be easily inhibited.

As a polymerization initiator used when polymerizing a monomer component (B-a), a monomer component (B-b), and a monomer component (B-c) in the acrylic-based rubber-containing polymer (B), the known initiators may be used, and the examples disclosed in the description on the thermoplastic polymer (A1) may be used. They may be used singly or in combination of two or more thereof.

When as a method of preparing the latex of an acrylic-based rubber-containing polymer (B), it is prepared by a polymerization method including supplying the monomer component (B-c) and monomer component (B-b), respectively,

EP 2 910 582 B1

in order into a reactor after performing the polymerization by supplying an emulsion prepared by mixing a monomer component (B-a) with water and a surfactant into the reactor, it is preferable that after increasing the temperature of aqueous solution in the polymerization vessel including ferrous sulfate, disodium ethylenediaminetetraacetate, and Rongalite to a polymerization temperature, the emulsion prepared by mixing the monomer component (B-a) with water and a surfactant be supplied to the reactor and then be polymerized, and then, sequentially, the monomer component (B-c) and monomer component (B-b) be sequentially supplied into the reactor and then is polymerized.

Examples of the polymerization temperature for obtaining the latex of the acrylic-based rubber-containing polymer (B) may be 40 to 120°C, but depends on a type or amount of the polymerization initiator used.

<Thennoplastic polymer (C)>

The thermoplastic polymer (C) is a polymer including an alkyl methacrylate unit (exclusive of i-butyl methacrylate) as a main component.

The acrylic resin composition that constitutes a film and the acrylic resin film of the invention may include a thermoplastic polymer (C). By including the thermoplastic polymer (C), if necessary, it is possible to impart thermal resistance and flexibility to the obtained acrylic resin film.

The polymer having an alkyl methacrylate unit as a main component is preferably a polymer obtained by polymerizing the monomer component including 50 to 100% by mass of alkyl methacrylate, 0 to 50% by mass of alkyl acrylate, and 0 to 49% by mass of other monomer having a double bond capable of being copolymerized with them in terms of the thermal resistance of the acrylic resin film.

In detail, as these monomers, the examples disclosed in the description on the thermoplastic polymer (A1) and acrylic-based rubber polymer (A2a) may be used. They may be used singly or in combination of two or more thereof.

The content of alkyl methacrylate in the monomer component for preparing a thermoplastic polymer (C) is preferably 50 to 100% by mass, more preferably 85 to 99.9% by mass, and most preferably 92 to 99.9% by mass in terms of the thermal resistance of the acrylic resin film.

The content of alkyl acrylate is preferably 0 to 40% by mass, more preferably 0.1 to 15% by mass, and still more preferably 0.1 to 8% by mass in terms of the thermal resistance of the acrylic resin film.

The content of other monomer having a double bond capable of being polymerized with them is preferably 0 to 49% by mass in terms of the thermal resistance of the acrylic resin film.

Examples of the method of polymerizing a thermoplastic polymer (C) may include a suspension polymerization method, an emulsification polymerization method, and an agglomerated polymerization method.

<Fluororesin (D)>

The acrylic resin film of the invention may include a fluororesin (D). The fluororesin (D) is not particularly limited, and the known flouroresin may be used.

Examples of the fluororesin (D) may include other composite resins having polyvinylidene fluoride, an ethylene/tetrafluoroethylene-based copolymer, polychlorotrifluoroethylene, polytetrafluoroethylene, polyvinyl fluoride, a tetrafluoroethylene-hexafluoropropylene-based copolymer, a tetrafluoroethylene/ perfluoro(propylvinyl ether)-based copolymer, a tetrafluoroethylene/vinylidene fluoride-based copolymer, a copolymer with acrylic-based monomers, such as, vinylidene fluoride and alkyl (meth)acrylate, and a vinylidene fluoride-based copolymer, as a main component. They may be used singly or in combination of two or more thereof. Specifically, in terms of compatibility with an acrylic resin, a vinylidene fluoride-based resin is preferable.

The vinylidene fluoride-based resin is not particularly limited as long as it is a vinyl monomer having a vinylidene fluoride monomer unit, and a homopolymer of vinylidene fluoride may be used and also a copolymer of vinylidene fluoride with other vinyl compound monomers may be used. Examples of other vinyl monomer capable of being copolymerized with vinylidene fluoride may include fluorinated vinyl monomers, such as, vinyl fluoride, tetrafluoroethylene, trifluoroethylene ethylene chloride, and propylene hexafluoride and vinyl monomers, such as, styrene, ethylene, butadiene, and propylene.

For the content of the fluororesin (D), preferably, the acrylic resin is 10 to 95% by mass and the fluororesin (D) is 90 to 5% by mass, when the total amount of the acrylic resin, such as, a polymer (A), an acrylic-based rubber-containing polymer (B), and a thermal polymer (C), and fluororesin (D) is 100% by mass. More preferably, the acrylic resin is 15 to 70% by mass and the fluororesin (D) is 85 to 30% by mass, and still more preferably, the acrylic resin is 20 to 50% by mass and the fluororesin (D) is 80 to 50% by mass. By including 90 to 5% by mass of the fluororesin, it is possible to impart the desired toughness and chemical resistance to the obtained film.

In addition, the fluororesin (D) may be laminated at least on one side of the acrylic resin film of the invention, and then, used. The laminated fluororesin layer may be formed only with the fluororesin (D), or the mixed resin layer of the fluororesin (D) and other resins may be used.

<Acrylic resin composition>

The acrylic resin composition that constitutes the acrylic resin film of the invention uses a polymer (A) obtained by polymerizing a monomer component (the total amount of i-butyl methacrylate and other monomers is 100% by mass) including i-butyl methacrylate as an essential component. In addition, if necessary, any one or more types of an acrylic-based rubber-containing polymer (B), a thermoplastic polymer (C), and a fluororesin (D) may be included.

Examples of the shape of the acrylic resin composition may include an agglomerated material, a powder material, and a pellet material. Among them, the pellet material is preferable in terms of the handling of the acrylic resin composition.

The acrylic resin composition may include, if necessary, all kinds of mixing agents, such as, stabilizer, lubricant, a processing agent, a matting agent, a light diffusion agent, plasticizer, an impact-resistant, a foaming agent, filler, a coloring agent, antibiotics, an antifungal agent, a releasing agent, an antistatic agent, photo-stabilizer, and ultraviolet ray absorbent.

In the acrylic resin composition, in terms of imparting weather resistance to an acrylic resin film in order to protect the product using the acrylic resin film, ultraviolet ray absorbent and photo-stabilizer are preferably mixed.

The molecular weight of the ultraviolet ray absorbent mixed in the acrylic resin composition is preferably 300 or more, and more preferably 400 or more. When the molecular weight of the ultraviolet ray absorbent is 300 or more, it is easy to inhibit the contamination of the mold used at the time of preparing an acrylic resin film.

As an example of a type of ultraviolet ray absorbent, there may be benzotriazole-based ultraviolet ray absorbent and triazine-based ultraviolet ray absorbent.

As the commercially available benzotriazole-based ultraviolet ray absorbent, for example, there may be Tinuvin 234 prepared by BASF, and ADK STAB LA-31 prepared by ADEKA CORPORATION (all the names are trade names).

As the commercially available ultraviolet ray absorbent, for example, there may be Tinuvin 1577 prepared by BASF and LA-F70 prepared by ADEKA CORPORATION (all the names are trade names).

<<Acrylic resin film>>

The acrylic resin film of the invention may be obtained by molding the acrylic resin composition.

The thickness of the film is preferably 10 to 500 $\mu$m, more preferably 20 to 300 $\mu$m, and still more preferably 30 to 200 $\mu$m in terms of the flexibility and handling property of the acrylic resin film.

The light transmittance of the acrylic resin film is preferably 80% or more, more preferably 83% or more, and still more preferably 85% or more as the total light transmittance measured based on JIS K7361-1. When the total light transmittance is 80% or more, the light required for the generation by sun light is sufficiently transmitted, and thus, it is possible to be used as a surface protective material of a solar cell.

The haze of the acrylic resin film is not particularly limited as long as the total light transmittance is 80% or more, but when the acrylic resin film is used as a surface protective material, in terms of the beautiful appearance of a solar cell, it is preferably 50% or less, more preferably 40% or less, and still more preferably 30% or less.

Examples of a method of preparing an acrylic resin film may include a melt extrusion method, such as, a melt casting method, a T-die method, and an inflation method, and a calendar method, but in terms of economic feasibility, the T-die method is preferable.

The acrylic resin film may be a roll-type product prepared by winding a film up to a tubular object such as a paper pipe using a winding machine after forming the film using an extruder, and the like. In addition, if necessary, a stretching process, such as, a uniaxial stretching (a machine direction or lateral direction (the direction that is perpendicular to the machine direction)) and a biaxial stretching (a sequential biaxial stretching and simultaneous biaxial stretching) according to the known stretching process during a film forming process may be established.

In addition, in order to impart the performance, such as, chemical resistance and thermal resistance to an acrylic resin film, the acrylic resin film may be a laminated film (hereinafter, simply referred to as "a film") laminated with a resin including the above-described fluororesin (D) or the resin including the fluororesin (D). By using the laminated fluororesin layer as a surface, it is possible to improve weather resistance and chemical resistance. The thickness of the fluororesin layer is preferably 2 to 30 $\mu$m, and more preferably 2 to 15 $\mu$m.

The method of preparing a laminated film is not particularly limited, and the laminated film may be prepared by using the known method. Examples of the preparing method may include a method of forming a laminated structure of an acrylic resin composition and a fluororesin (D) with a co-extrusion molding method through a feed block die or multi-manifold die, or a method including molding each of the acrylic resin composition and fluororesin (D) in a film shape by a melt extrusion method using a T die and laminating two types of the films by a heat laminating method. In addition, there may be an extrusion lamination method including forming the acrylic resin composition in a film shape, and then, laminating the fluororesin (D) by a melt extrusion method. In this case, the acrylic resin composition and the fluororesin (D) are replaced, and then, the laminated film may be prepared. In addition, there may be a method including molding the acrylic resin composition and the fluororesin (D) in a film shape, respectively, and then, laminating the obtained films by establishing an adhesive layer and/or sticking layer.

Especially, in terms of economic feasibility and process simplification, the laminated structure of the acrylic resin composition and the fluororesin (D) is preferably formed by a co-extrusion molding method. In detail, for example, the co-extrusion molding method through a feed block die or a multi-manifold die as described above is more preferable.

In addition, when a melt extrusion is performed, in order to remove nucleus or foreign materials causing poor appearance, while the resin composition in a melted state, which constitutes each of the layers, is filtered with a screen mesh having 200 meshes or more, the extrusion is preferably performed.

A fine structure may be formed on the surface of the acrylic resin film. Examples of the method of forming a fine structure may include a thermal transfer method and an etching method.

Among them, the thermal transfer method including pressing a heated mold on the surface of the acrylic resin film after heating the mold having a fine structure to form the fine structure on the surface of the acrylic resin film is preferable in terms of productivity and economic feasibility.

Examples of the thermal transfer method may include a method of thermal-transferring the fine structure in a single wafer by heat-pressing a mold having a fine structure on the acrylic resin film cut and brought out from a roll-type article, and a continuous shaping method of thermal-transferring the fine structure on the surface of the acrylic resin film by inserting the acrylic resin film unwound from a roll-type article using a nip roll into a heated mold having a fine structure in a belt-type, and then pressing.

Examples of a method of manufacturing the mold having the fine structure may include a sandblast method, an etching method, and an electric discharge processing method.

This acrylic resin films may be laminated themselves, and also, may be laminated on other basic materials. A shape of the basic material that is used for manufacturing a laminate is not particularly limited, but for example, a film, a sheet, and the basic materials having a shape, such as, a molded article having a three-dimensional shape, may be used.

As a type of basic materials that constitute the acrylic resin film and a laminate, the basic materials formed with the known materials may be used, and examples of the type thereof may include a general-purpose thermoplastic or thermosetting resin, such as, a polyolefin-based resin, a polystyrene resin, an ABS resin (an acrylonitrile-butadiene-styrene copolymer), an AS resin (an acrylonitrile-styrene copolymer), an acrylic-based resin, an urethane-based resin, a unsaturated polyester resin, and an epoxy resin; a general-purpose engineering resin, such as, a polyphenylene oxide polystyrene-based resin, a polycarbonate resin, polyacetal, polycarbonate modified polyphenylene ether, and polyethylene terephthalate; a super engineering resin, such as, polysulfone, polyphenylene sulfide, polyphenylene oxide, polyether imide, polyimide, liquid crystal polyester, and polyallyl-based thermal resistance resin; a composite resin prepared by adding a reinforcing material, such as, a glass fiber or inorganic filler (talc, calcium carbonate, silica, mica, and the like) and a modifying agent, such as, a rubber component, or various modified resins.

In addition, according to the acrylic resin film of the invention, the adhesion to a polyolefin-based resin becomes good. Specific examples of the polyolefin-based resin may include polyethylene, polypropylene, polybutene, polymethyl pentene, an ethylene-propylene copolymer, an ethylene-propylene-butene copolymer, an ethylene-vinyl acetate copolymer (EVA), and olefin-based thermoplastic elastomer. Among them, one having excellent adhesion to an EVA that is generally used for an encapsulant of a solar cell is preferable.

When the acrylic resin film is laminated on a basic material, a method of laminating both of them is not particularly limited, but for a basic material capable of being laminated with heat, for example, the known methods, such as, a heat lamination method and a vacuum heat lamination method may be used. When the appearance in a mat-type is desired, a heat lamination method using an embossed-processed roll or mold may be used. When laminating and molding on the basic material having a three-dimensional shape, for example, the known molding methods, such as, an insert molding method, an in mold molding method, and a TOM molding method, may be used. In addition, it is possible to use the lamination by co-extrusion.

For a basic material that is difficult to be laminated by heat, the basic material may be laminated by interposing an adhesive layer by a general adhesive, such as, an acrylic-based or a urethane-based adhesive when the basic material is laminated on other basic materials. Specific examples of the basic material that is difficult to be laminated by heat may include a wood board, such as, a wood single board, a wood plywood, a particle board, and a medium density fiberboard (MDF), a water board, such as, a woody fiber board, metals, such as, iron and aluminum, glass, and the like.

An intermediate layer may be provided between the acrylic resin film and the basic material, if necessary. The intermediate layer that is used if necessary may be a printing layer, a plating layer, an adhesive layer, a coloring resin layer, and the like.

In order to improve the adhesion to other basic materials on the surface of the acrylic resin film, if necessary, a surface treatment may be applied. Examples of the surface treatment may include an ultraviolet irradiation treatment, a corona discharge treatment, an ozone treatment, a low-temperature plasma treatment using an oxygen gas, a nitrogen gas, a fluorine gas, and the like, a decompression plasma treatment, a plasma treatment, such as, an atmospheric plasma treatment, a flame treatment, an oxidation treatment that is performed by using chemicals, an alkali saponification treatment, and the like. Among them, the corona discharge treatment and plasma treatment that exhibit high effect on improving adhesion are preferable. In addition, when performing the surface treatment, a pre-treatment may be performed if necessary.

In addition, here, for the plasma treatment, a solid dielectric is provided at least on one opposed side of a pair of electrodes under the environment filled with any kinds of atmosphere gas and certain pressure; a pulse electric field is supplied between a pair of electrodes to generate plasma, and then, the generated plasma is treated. The treatment condition of the plasma treatment may be properly selected according to the shape or quality of the basic material, and the pressure or a type of gas is not particularly limited. In terms of the safety of a treatment and simplification of a device, it is preferable to select the atmospheric pressure plasma treatment.

The acrylic resin film of the invention and a laminate laminated with the acrylic resin film may be used as a surface protective material of a solar cell, and is very suitably used as a use that conventionally uses an acrylic resin film. As the use, for example, it may be used as a substitute film of a thick film coating by painting for imparting the feeling of depth to a molded article, and it is very suitably used as various uses, for example, automotive interior uses, such as, an instrumental panel, a console box, a meter cover, a door lock bezel, a handle, a power window switch base, a center cluster, and a dashboard; automotive exterior uses, such as, a weather strip, a bumper, a bumper guard, a side mudguard, a body panel, a spoiler, a front grille, a strut mount, a wheel cap, a center pillar, a door mirror, a center ornament, a side molding, a door molding, a window molding, a window, a head lamp cover, a tail lamp cover, and a part against wind; a housing use, such as, a front panel of an AV device or furniture good, an emblem, and a cellular phone; a display window use; a button use: a furniture exterior material use; a building interior material use, such as, the surface of a wall, ceiling, and floor; a building exterior material use, such as, an outer wall like siding, wall, roof, gate, and bargeboard; a furniture surface decoration use, such as, windowsill, door, balustrade, threshold, and a lintel; an optical member use, such as, various displays, lens, mirrors, goggles, and glass windows; exterior and interior uses of various vehicles other than a car, such as, a subway, a plane, and a ship; various packaging containers, such as, a bottle, a cosmetic container, and a props box; and general merchandise uses, such as, a free gift and a props material.

<<Solar cell module>>

By using the acrylic resin film of the invention as a surface protective material, a solar cell module having excellent weather resistance and light transmittance, in which the surface protective material and encapsulant are not peeled off, may be obtained.

A structure of the solar cell module is not particularly limited, and for example, there may be a structure prepared by laminating, from the side of sun light incident, the acrylic resin film of the invention, as a surface protective material, an encapsulant, a solar cell, an encapsulant, and a back sheet, in order.

As an encapsulant, the known encapsulants may be selected as long as they has excellent adhesion to the acrylic resin film of the invention, a solar cell, and a back sheet, excellent transparency, and excellent impact resistance. Examples of the known encapsulant may include a fluorine-based resin, an ionomer resin, an ethylene-vinyl acetate copolymer (EVA), an ethylene-(meth)acrylic acid copolymer, a polyethylene resin, a polypropylene resin, an acid-modified polyolefin-based resin prepared by organizing a polyolefin-based resin, such as, polyethylene or polypropylene with an unsaturated carboxylic acid, such as, an acrylic acid, an itaconic acid, a maleic acid, and a fumaric acid, a polyvinyl butyral resin, a silicone-based resin, an epoxy-based resin, a (meth)acrylic-based resin, a polyurethane-based resin, and mixtures of one or two or more of other resins. Among them, in terms of easy availability and adhesion to the acrylic resin film of the invention, it is preferable to use an ethylene-vinyl acetate copolymer (EVA).

As the adhesion between the acrylic resin film and the encapsulant, when the following specimens are tested under the following conditions, the peeling strength between the acrylic resin film (first layer) and the encapsulant (second and third layers) is preferably 10 N/15 mm or more, more preferably 12 N/15 mm or more, and still more preferably 15 N/15 mm or more. When the peeling strength is 10 N/15 mm or more, even though the solar cell module using the acrylic resin film is exposed in the outdoors, it is possible to inhibit the peeling and elimination of the acrylic resin film, and thus, it is preferable.

<Specimen>

First layer: Acrylic resin film
Second layer: Ethylene-vinyl acetate copolymer film
Third layer: Support film

The above films in order are laminated, and then, heat-pressed under a vacuum atmospheric pressure at 135°C for 15 minutes using a vacuum heat-pressing device to obtain a laminate.

• The laminate is cut to be 15 mm × 150 mm.

<Test conditions>

The first layer of the specimen only is chucked, and the second layer and third layer are together chucked. Since then, when peeling the specimen off, the peeling strength is measured.

Peeling angle: 180°
Peeling rate: 100 mm/min

In addition, the chucking refers to the inserting and fixing of the thin specimen in a film shape.

A solar cell is not particularly limited as long as it is known, but examples thereof may include various solar cells, such as, a monocrystalline silicon solar cell, a polycrystalline silicon solar cell, an amorphous silicon solar cell, a micro-crystalline silicon solar cell, a spherical silicon solar cell, a thin-film crystalline silicon solar cell, an amorphous silicon-germanium solar cell, a cadmium telluride solar cell, a gallium arsenide solar cell, a chalcopyrite solar cell prepared by using I-III-VI group compound formed of Cu, In, Ga, Al, Se, S, and the like, called a copper indium selenide-type, an organic thin-film solar cell, and a die-sensitized solar cell.

As a back sheet, an insulating sheet may be used, and also, it is required to have excellent scratching resistance or impact absorption in terms of protecting a solar cell by having thermal resistance, weather resistance, water resistance, a steam barrier property, and an oxygen barrier property and also excellent physical or chemical strength. Examples of the back sheet may include a metal plate, such as, a glass plate or a stainless plate, a polyamide-based resin, a polyester-based resin, a polyethylene-based resin, a polypropylene-based resin, a polystyrene-based resin, a polycarbonate-based resin, an acetal-based resin, a cellulose-based resin, a (meth)acrylic-based resin, and other various resin sheets. Examples of the resin sheet may include a resin sheet having a biaxial stretched thickness of about 10 to 500 μm. In addition, in order to improve the steam barrier property and oxygen barrier property, an inorganic film may be formed at least on one side of the resin sheet.

A method of manufacturing a solar cell module is not particularly limited, and a solar cell module may be manufactured by the known method. For example, when using a vacuum laminator, there may be a method of manufacturing a solar cell including heat-pressing molding the following laminated thing in an integral molded article by a heat-pressing molding using a general molding method, such as a heat-pressing lamination method, in which a releasing sheet, the acrylic resin film of the invention, an encapsulant, a solar cell, an encapsulant, and a back sheet are sequentially laminated on the surface of the heater of the laminator; if necessary, other materials are arbitrarily laminated between each of the layers; then, the laminated thing is formed in an integral molded article by a vacuum aspiration.

The invention will be described with reference to the following Examples.

EXAMPLES

Hereinafter, the invention will be described based on Examples. In addition, hereinafter, "part" refers to "part by mass." In addition, the abbreviations used in the following description are as follows.

i-BMA: i-butyl methacrylate
MMA: methyl methacrylate
n-BA: n-butyl acrylate
St: styrene
1,3-BD: butylene glycol dimethacrylate
AMA: allyl methacrylate
AIBN: 2,2'-azobisisobutyronitrile
CHP: cumene hydroperoxide
t-BH: t-butyl hydroperoxide
n-OM: n-octyl mercaptan
EDTA: ethylene diamine tetra-acetic acid disodium
SFS : sodium formaldehyde sulfoxylate (Rongalite)
RS610NA: sodium polyoxyethylene alkyl ether phosphate (prepared by Toho Chemical Industry Co., Ltd., Trade Name: PHOSPHANOL RS610NA)

For Examples and Comparative Examples, the respective physical properties were measured by the following methods.

(1) Mass average molecular weight (Mw) and molecular weight distribution

The mass average molecular weight (Mw) and number average molecular weight of the polymer was obtained from a calibration curve of standard polystyrene by performing the measurement using a polymer dissolved in tetrahydrofuran as a sample under the condition of eluent, tetrahydrofuran and a measuring temperature of 40°C using a gel permeation chromatography (Device name "HLC-8200", manufactured by Tosoh Corporation) and column (Trade Name, "TSK-GEL-SUPER-MULTIPORE-HZ-H", manufactured by Tosoh Corporation, an internal diameter of 4.6 mm × a length of 15 cm × two columns).

Furthermore, the molecular weight distribution was calculated using the following equation.

$$\text{Molecular weight distribution} = (\text{mass average molecular weight})/(\text{number average molecular weight})$$

(2) Optical property of acrylic resin film (total light transmittance and haze)

The total light transmittance and haze of the acrylic resin film were measured under the following conditions.

In addition, the total light transmittance and haze were measured using NDH2000 manufactured by Nippon Denshoku Industries Co., Ltd. based on JIS K7361-1 and JIS K7136, respectively.

(3) Adhesion between acrylic resin film and encapsulant (EVA)

The laminate prepared by laminating a releasing sheet, the acrylic resin film of the invention, an EVA sheet (manufactured by C. I. KASEI CO., LTD., Trade Name "CIKcap(R) FLCE-51 ", a thickness of 450 $\mu$m) as a thermosetting encapsulant, an acrylic resin film (manufactured by Mitsubishi Rayon Co., Ltd., Trade Name: "Akuripuren HBX-N47", a thickness of 125 $\mu$m) as a support, and a releasing sheet in order on a vacuum laminator (manufactured by NPC Incorporated, Type: LM-50 × 50-S type) having heaters at the top and bottom thereof was set in a chamber of a vacuum laminator heated at 135°C. After being set, the vacuum was applied in the chamber for 10 minutes; after confirming the performance of sufficient vacuum, the heat-pressing was performed under a vacuum atmospheric pressure at 135°C for 15 minutes to obtain a laminated laminate; from the laminated laminate, a peeling sheet was removed to obtain the laminate prepared by laminating an acrylic resin film and an encapsulant. Then, the laminate was cut to be 15 mm × 150 mm, and then, the peeling strength thereof was measured under the conditions of a peeling angle of 180° and a peeling rate of 100 mm/min, and then, the adhesion thereof was determined.

(4) Film-forming property of acrylic resin film

Whether or not the pellet of the acrylic resin composition could be molded in a film shape under the condition of a cylinder temperature of 200°C to 240°C, a T-die temperature of 250°C, and a cooling roll temperature of 80°C in a film shape using a non-vented screw-type extruder (L/D = 26) having a diameter of 40 mm $\phi$ installed with a T-die having a width of 300 mm was estimated based on the following criteria.

○: It is possible to mold it in a film shape.
×: It is impossible to mold it in a film shape.

[Preparation Example 1; Reference Example] Thermoplastic polymer (A1-1)

300 parts (3000 gram) of deionized water, 98 parts of i-BMA, 2 parts of n-BA, 1.0 part of n-OM as a chain transfer agent, and 1.1 parts of sodium dodecyl benzenesulfonate were added to a separable flask (a volume of 5 liters) having a thermometer, a nitrogen inlet tube, a cooling tube, and a stirrer; and then, a nitrogen substitution was performed in the inside atmosphere of the flask by passing a nitrogen gas stream through the separable flask. Then, the internal temperature was increased by 60°C, and then, 0.15 parts of persulfuric acid potassium and 5 parts of deionized water were added thereto. Then, by continuously performing a heat-stirring for 2 hours, the polymerization was completed to obtain the latex of a thermoplastic polymer (A1-1).

The obtained latex of the thermoplastic polymer (A1-1) was dropped in 400 parts of warmed water of 70°C including 5 parts of calcium acetate, the temperature thereof was increased by 90°C, and then, the coagulation was performed. The obtained coagulated product was isolated and washed, and then, dried at 60°C for 16 hours to obtain a thermoplastic polymer (A1-1).

The mass average molecular weight (Mw) of the polymer (A1-1) was 30,000 and the molecular weight distribution thereof was 1.7.

[Preparation Example 2, Reference Example] Thermoplastic polymer (Al-2)

260 parts of deionized water, 100 parts by mass of i-BMA, 0.1 part of AIBN as an initiator, and 0.4 part of n-OM as a chain transfer agent were added to a separable flask (a volume of 10 liters) having a thermometer, a nitrogen inlet tube, a cooling tube, and a stirrer.

The air in the reaction container was sufficiently substituted with a nitrogen gas; then, while being stirred, as a dispersant, 0.02 part of methyl methacrylate/potassium methacrylate/2-sulfonate ethyl sodium salt methacrylate copolymer and 0.3 part of sodium sulfate were added thereto; and then, the polymerization was performed in a nitrogen gas stream by heating it by 80°C. After observing the polymerization exothermic reaction, the temperature was increased by 85°C, and then, the temperature was further maintained for 60 minutes to complete the polymerization. The obtained polymer was dehydrated and dried to obtain a thermoplastic polymer (A1-2).

The mass average molecular weight (Mw) of the polymer (A1-2) was 50,000 and the molecular weight distribution thereof was 1.8.

[Preparation Example 3, Reference Example] Thermoplastic polymer (A1-3)

A thermoplastic polymer (A1-3) was obtained in the same method as Preparation Example 2 except that 0.14 part of n-OM as a chain transfer agent was added when performing the polymerization.

The mass average molecular weight (Mw) of the polymer (A1-3) was 160,000 and the molecular weight distribution thereof was 2.0.

[Preparation Example 4, Reference Example] Thermoplastic polymer (A1-4)

A thermoplastic polymer (A1-4) was obtained in the same method as Preparation Example 1 except that a chain transfer agent was not added when performing the polymerization. The mass average molecular weight (Mw) of the polymer (A1-4) was 2,500,000 and the molecular weight distribution thereof was 5.5.

[Preparation Example 5, Reference Example] Thermoplastic polymer (A1-5)

A thermoplastic polymer (A1-5) was obtained in the same method as Preparation Example 2 except that 75 parts of i-BMA, 24 parts of MMA, 1 part of n-BA, and 0.08 part of n-OM were added when performing the polymerization. The mass average molecular weight (Mw) of the polymer (A1-5) was 220,000 and the molecular weight distribution thereof was 2.2.

[Preparation Example 6, Reference Example] Thermoplastic polymer (A1-6)

A thermoplastic polymer (A1-6) was obtained in the same method as Preparation Example 2 except that 50 parts of i-BMA, 49 parts of MMA, 1 part of n-BA, and 0.08 part of n-OM were added when performing the polymerization. The mass average molecular weight (Mw) of the polymer (A1-6) was 220,000 and the molecular weight distribution thereof was 2.1.

[Preparation Example 7, Reference Example] Thermoplastic polymer (A1-7)

A thermoplastic polymer (A1-7) was obtained in the same method as Preparation Example 2 except that 25 parts of i-BMA, 74 parts of MMA, 1 part of n-BA, and 0.08 part of n-OM were added when performing the polymerization. The mass average molecular weight (Mw) of the polymer (A1-7) was 210,000 and the molecular weight distribution thereof was 2.2.

[Preparation Example 8] Preparation of rubber-containing polymer (A2-1)

8.5 parts of ion-exchange water was added to a container having a stirrer and a cooler, a monomer component (A2-a-1-1) constituted of 0.3 part of MMA, 4.5 parts of n-BA, 0.2 part of 1,3-BD, 0.05 part of AMA, and 0.025 part of CHP was added thereto, and then, stirred and mixed. Since then, while 1.1 parts of RS610NA as an emulsifier was stirred, the emulsifier was added to the container, and the stirring was further kept for 20 minutes to prepare an emulsion including the monomer component (A2-a-1-1).

Since then, 186.5 parts of ion-exchange water was added to a reaction container having a cooler, the temperature of the container was increased to 70°C, and then, the mixture prepared by adding 0.20 part of SFS, 0.0001 part of ferrous sulfate, and 0.0003 part of EDTA to 5 parts of ion-exchange water was also integrally added thereto. Since then, while being stirred under nitrogen, an emulsion including a monomer component (A2-a-1-1) was dropped in the container over 8 minutes, and was continuously reacted for 15 minutes to obtain a polymer constituted of the monomer component (A2-a-1-1).

Continuously, a monomer component (A2-a-2-1) constituted of 1.5 parts of MMA, 22.5 parts of n-BA, 1.0 part of 1,3-BD, 0.25 part of AMA, and 0.016 part of CHP was added in the container over 90 minutes, and then, was continuously reacted for 60 minutes to obtain an acrylic-based rubber polymer (A2a-1). Here, the Tg of the acrylic-based rubber polymer (A2a-1) was -47°C.

Next, a monomer component (A2-b-1-1) constituted of 6.0 parts of MMA, 4.0 parts of n-BA, 0.015 part of AMA, and 0.013 part of CHP was dropped in the container over 45 minutes, and then, was continuously reacted for 60 minutes to form a polymer. Here, the Tg of the polymer (A2b1-1) constituted of the monomer component (A2-b-1-1) was 20°C.

Since then, a monomer component (A2-b-2-1) constituted of 14.4 parts of MMA, 0.6 part of n-BA, 45 parts of i-BMA, 0.08 part of n-OM, and 0.075 part of t-BH was dropped in the container over 140 minutes, and then, was continuously reacted for 60 minutes to obtain the latex of an acrylic-based rubber polymer (A2-1). Here, the Tg of the polymer (A2b2-1) constituted of the monomer component (A2-b-2-1) was 60°C.

The obtained latex of the rubber-containing polymer (A2-1) was filtered using a vibration filtering device attaching a mesh (average mesh opening of 62 $\mu$m) made by SUS as a filter medium, salt-precipitated in aqueous solution including 3 parts of calcium acetate, wash-collected, and then, dried to obtain a rubber-containing polymer (A2-1) in a powder phase.

The compositions of the rubber-containing polymer (A2-1) are summarized in Table 1.

[Preparation Example 9] Preparation of rubber-containing polymer (A2-2)

The preparation of the acrylic-based rubber polymer (A2a-2) was performed in the same method as Preparation Example 8.

Continuously, a monomer component (A2-b-1-2) constituted of 6.0 parts of MMA, 4.0 parts of n-BA, 0.075 part of AMA, and 0.013 part of CHP was dropped in a reaction container over 45 minutes, and then, continuously reacted for 60 minutes to obtain an intermediate polymer. Here, the Tg of the polymer (A2b1-2) constituted of the monomer component (A2-b-1-2) was 20°C.

Since then, a monomer component (A2-b-2-2) constituted of 29.4 parts of MMA, 0.6 part of n-BA, 30 parts of i-BMA, 0.22 part of n-OM, and 0.075 part of t-BH was dropped in a reaction container over 140 minutes, and then, continuously reacted for 60 minutes to obtain the latex of the rubber-containing polymer (A2-2). Here, the Tg of the polymer (A2b2-2) constituted of the monomer component (A2-b-2-2) was 73°C.

The obtained latex of the rubber-containing polymer (A2-2) was filtered using a vibration filtering device attaching a mesh (average mesh opening of 62 $\mu$m) made by SUS as a filter medium, salt-precipitated in aqueous solution including 3 parts of calcium acetate, wash-collected, and then, dried to obtain a rubber-containing polymer (A2-2) in a powder phase.

The compositions of the rubber-containing polymer (A2-2) are summarized in Table 1.

[Preparation Example 10] Preparation of rubber-containing polymer (A2-3)

The preparations of the acrylic-based rubber polymer (A2a-3) and the polymer (A2b1-3) constituted of the monomer component (A2-b-1-3) were performed in the same method as Preparation Example 9.

Since then, a monomer component (A2-b-2-3) constituted of 44.4 parts of MMA, 0.6 part of n-BA, 15 parts of i-BMA, 0.22 part of n-OM, and 0.075 part of t-BH was dropped in a reaction container over 140 minutes, and then, continuously reacted for 60 minutes to obtain the latex of the rubber-containing polymer (A2-3). Here, the Tg of the polymer (A2b2-3) constituted of the monomer component (A2-b-2-3) was 87°C.

The obtained latex of the rubber-containing polymer (A2-3) was filtered using a vibration filtering device attaching a mesh (average mesh opening of 62 $\mu$m) made by SUS as a filter medium, salt-precipitated in aqueous solution including 3 parts of calcium acetate, wash-collected, and then, dried to obtain a rubber-containing polymer (A2-3) in a powder phase.

The compositions of the rubber-containing polymer (A2-3) are summarized in Table 1.

[Preparation Example 11, Reference Example] Preparation of rubber-containing polymer (A2-4)

300 parts of ion-exchange water, 0.05 part of sodium carbonate, and 1.0 part of RS610NA were added to a container having a cooler, the temperature of the container was increased by 70°C, and then, the mixture prepared by adding 0.48 part of SFS, 0.00004 part of ferrous sulfate, and 0.00012 part of EDTA in 5 parts of ion-exchanged water was integrally added thereto. Since then, while being stirred under nitrogen, a monomer component (A2-a-4) constituted of 50.9 parts of n-BA, 11.6 parts of St, 0.56 part of AMA, 1.0 part of RS610NA, and 0.19 part of t-BH was dropped in a reaction container over 185 minutes, and was continuously reacted for 120 minutes to obtain the acrylic-based rubber polymer (A2a-4) constituted of the monomer component (A2-a-4). Here, the Tg of the acrylic-based rubber polymer (A2a-4) was -36°C.

Since then, 5 parts of ion-exchange water and 0.12 part of SFS were integrally added thereto; after 15 minutes, a monomer component (A2-b-4) constituted of 35.6 parts of MMA, 1.9 parts of MA, 0.15 part of n-OM, 0.06 part of t-BH, and 0.25 part of RS610NA was dropped in a reaction container over 90 minutes, and then, continuously reacted for 60 minutes to obtain the latex of the rubber-containing polymer (A2-4). Here, the Tg of the polymer (A2b-4) constituted of the monomer component (A2-b-4) was 71°C.

The obtained latex of the rubber-containing polymer (A2-4) was filtered using a vibration filtering device attaching a mesh (average mesh opening of 62 $\mu$m) made by SUS as a filter medium, salt-precipitated in aqueous solution including 2.5 parts of calcium acetate, wash-collected, and then, dried to obtain a rubber-containing polymer (A2-4) in a powder phase.

The compositions of the rubber-containing polymer (A2-4) are summarized in Table 1.

[Table 1]

Table 1 (*Preparation Example 11 is a Reference Example)

| Rubber-containing polymer (A2) | | Raw material (part by mass) | Preparation Example 8 A2-1 | Preparation Example 9 A2-2 | Preparation Example 10 A2-3 | Preparation Example 11* A2-4 |
|---|---|---|---|---|---|---|
| Acrylic-based rubber polymer (A2a) | A2-a-1 | MMA | 0.3 | 0.3 | 0.3 | - |
| | | n-BA | 4.5 | 4.5 | 4.5 | 50.9 |
| | | St | - | - | - | 11.6 |
| | | 1,3-BD | 0.2 | 0.2 | 0.2 | - |
| | | AMA | 0.05 | 0.05 | 0.05 | 0.56 |
| | | RS610NA | 1.1 | 1.1 | 1.1 | 1 |
| | | CHP | 0.025 | 0.025 | 0.025 | - |
| | | t-BH | - | - | - | 0.19 |
| | A2-a-2 | MMA | 1.5 | 1.5 | 1.5 | - |
| | | n-BA | 22.5 | 22.5 | 22.5 | - |
| | | AMA | 0.25 | 0.25 | 0.25 | - |
| | | 1,3-BD | 1 | 1 | 1 | - |
| | | CHP | 0.016 | 0.016 | 0.016 | - |
| | Tg (°C) | | -47 | -47 | -47 | -36 |
| | Content of acrylic-based rubber polymer (%) | | 30.2 | 30.2 | 30.2 | 62.7 |

(continued)

| Rubber-containing polymer (A2) | | Raw material (part by mass) | Preparation Example 8 A2-1 | Preparation Example 9 A2-2 | Preparation Example 10 A2-3 | Preparation Example 11* A2-4 |
|---|---|---|---|---|---|---|
| Polymer (A2b) | A2-b-1 | MMA | 6 | 6 | 6 | - |
| | | n-BA | 4 | 4 | 4 | - |
| | | AMA | 0.015 | 0.075 | 0.075 | - |
| | | CHP | 0.013 | 0.013 | 0.013 | - |
| | | Tg (°C) | 20 | 20 | 20 | - |
| | A2-b-2 | MMA | 14.4 | 29.4 | 44.4 | 35.6 |
| | | n-BA | 0.6 | 0.6 | 0.6 | - |
| | | MA | - | - | - | 1.9 |
| | | i-BMA | 45 | 30 | 15 | - |
| | | n-OM | 0.08 | 0.22 | 0.22 | 0.15 |
| | | t-BH | 0.075 | 0.075 | 0.075 | 0.06 |
| | | RS610NA | - | - | - | 0.25 |
| | | Tg (°C) | 60 | 73 | 87 | 71 |

[Preparation Example 12, Reference Example] Preparation of acrylic-based rubber-containing polymer (B)

8.5 parts of deionized water was added in a container having a stirrer and a cooler, and a monomer component (B-a-1) constituted of 0.3 part of MMA, 4.5 parts of n-BA, 0.2 part of 1,3-BD, 0.05 part of AMA, and 0.025 part of CHP was added thereto, and then, the mixture thus obtained was stirred and mixed. Since then, 1.3 parts of RS610NA as an emulsifier was added while being stirred, and again, was further stirred for 20 minutes to prepare an emulsion including the monomer component (B-a-1).

Then, 186.5 parts of ion-exchange water was added in a reaction container having a cooler. After increasing the temperature thereof to 70°C, the mixture prepared by adding 0.20 part of SFS, 0.0001 part of ferrous sulfate, and 0.0003 part of EDTA to 5 parts of ion-exchange water was integrally added thereto. Since then, while being stirred under nitrogen, the emulsion including the monomer component (B-a-1) was dropped to the reaction container over 8 minutes, and then, was continuously reacted for 15 minutes to obtain a polymer constituted of the monomer component (B-a-1).

Since then, a monomer component (B-a-2) constituted of 1.5 parts of MMA, 22.5 parts of n-BA, 1.0 part of 1,3-BD, 0.25 part of AMA, and 0.016 part of CHP was added in a container over 90 minutes, and then, was continuously reacted for 60 minutes to obtain an acrylic-based rubber polymer (Ba). Here, the Tg of the acrylic-based rubber polymer (Ba) was -47°C.

Since then, a monomer component (B-c) constituted of 6.0 parts of MMA, 4.0 parts of n-BA, 0.075 part of AMA, and 0.013 part of CHP was dropped in the reaction container over 45 minutes, and then, was continuously reacted for 60 minutes to form an intermediate polymer. Here, the Tg of a polymer (Bc) constituted of the monomer component (B-c) was 20°C.

Since then, a monomer component (B-b) constituted of 55.2 parts of MMA, 4.8 parts of n-BA, 0.22 part of n-OM, and 0.075 part of t-BH was dropped in the reaction container over 140 minutes, and then, was continuously reacted for 60 minutes to obtain the latex of an acrylic-based rubber-containing polymer (B). Here, the Tg of the polymer (Bb) constituted of the monomer component (B-b) was 84°C.

The obtained latex of the acrylic-based rubber-containing polymer (B) was filtered using a vibration filtering device attaching a mesh (average mesh opening of 62 $\mu$m) made by SUS as a filter medium, salt-precipitated in aqueous solution including 3 parts of calcium acetate, wash-collected, and then, dried to obtain a rubber-containing polymer (B) in a powder phase.

The compositions of the acrylic-based rubber-containing polymer (B) are summarized in Table 2.

[Table 2]

Table 2 (*Reference Example)

| Acrylic-based rubber-containing polymer (B) | | Raw material (part by mass) | Preparation Example 12* B |
|---|---|---|---|
| Acrylic-based rubber polymer (Ba) | B-a-1 | MMA | 0.3 |
| | | n-BA | 4.5 |
| | | AMA | 0.05 |
| | | 1,3-BD | 0.2 |
| | | RS610NA | 1.1 |
| | | CHP | 0.025 |
| | B-a-2 | MMA | 1.5 |
| | | n-BA | 22.5 |
| | | AMA | 0.25 |
| | | 1,3-BD | 1 |
| | | CHP | 0.016 |
| | | Tg (°C) | -47 |
| B-c | | MMA | 6 |
| | | n-BA | 4 |
| | | AMA | 0.075 |
| | | | |
| | | CHP | 0.013 |
| | | Tg (°C) | 20 |
| B-b | | MMA | 55.2 |
| | | n-BA | 4.8 |
| | | n-OM | 0.22 |
| | | t-BH | 0.075 |
| | | Tg (°C) | 84 |

(Preparation of acrylic resin film and evaluation of physical properties)

[Example 1, Reference Example]

LA-31 (Trade Name) that is a benzotriazole-based ultraviolet ray absorbent prepared by ADEKA CORPORATION as an ultraviolet ray absorbent, LA-57 (Trade Name) that is hindered amine-based photo-stabilizer prepared by ADEKA CORPORATION as photo-stabilizer, and Irganox 1076 (Trade Name) that is a hindered phenol-based oxidation inhibitor prepared by BASF as an antioxidant were added in the combination amounts listed in Table 3 to an acrylic resin (A) constituted of 5 parts of the thermoplastic polymer (A1-1) obtained from Preparation Example 1, and 95 parts of an acrylic-based rubber-containing polymer (B), and the mixture thus obtained was mixed using a Henschel mixer to obtain an acrylic resin composition.
The acrylic resin composition was supplied to a degasifying twin-screw kneading extruder (manufactured by Toshiba Machine Co., Ltd., Trade Name: TEM-35B) that was heated to 230°C, and then, were blended to obtain a pellet material of the acrylic resin composition. In addition, the pellet was dried in a dehumidifying dryer at 80°C for a day.
By using the pellet of the acrylic resin composition obtained by drying, a film was formed under the conditions of a cylinder temperature of 200°C to 240°C, a T-die temperature of 250°C, and a cooling roll temperature of 80°C using a non-vented screw-type extruder (L/D = 26) having a diameter of 40 mm φ installed with a T-die having a width of 300 mm, the obtained acrylic resin film was wound on a paper pipe using a winding machine to obtain the rolled article of the acrylic resin film having a thickness of 125 μm.
As a result of measuring optical properties of the obtained acrylic resin film, it was confirmed that the total light transmittance was 92%, which means excellent light transmittance.

In addition, as a result of confirming the adhesion between the acrylic resin film and EVA, it was confirmed that the peeling strength was 15 N/15 mm, which means good adhesion.

The results are listed in Table 3.

[Example 2, Reference Example]

The same method as Example 1 was performed, except that 10 parts of the thermoplastic polymer (A1-1) and 90 parts of the acrylic-based rubber-containing polymer (B) were used.

The total light transmittance of the acrylic resin film was 89%, and as the adhesion to EVA, the peeling strength thereof was 15 N/15 mm, that means good adhesion.

The results are listed in Table 3.

[Example 3, Reference Example]

The same method as Example 1 was performed, except that 5 parts of the thermoplastic polymer (A1-2) and 95 parts of the acrylic-based rubber-containing polymer (B) were used.

The total light transmittance of the acrylic resin film was 91%, and as the adhesion to EVA, the peeling strength thereof was 15 N/15 mm, that means good adhesion.

The results are listed in Table 3.

[Example 4, Reference Example]

The same method as Example 1 was performed, except that 10 parts of the thermoplastic polymer (A1-2) and 90 parts of the acrylic-based rubber-containing polymer (B) were used.

The total light transmittance of the acrylic resin film was 89%, and as the adhesion to EVA, the peeling strength thereof was 15 N/15 mm, that means good adhesion.

The results are listed in Table 3.

[Example 5, Reference Example]

The same method as Example 1 was performed, except that 3 parts of the thermoplastic polymer (Al-3) and 97 parts of the acrylic-based rubber-containing polymer (B) were used.

The total light transmittance of the acrylic resin film was 92%, and as the adhesion to EVA, the peeling strength thereof was 22 N/15 mm, that means good adhesion.

The results are listed in Table 3.

[Example 6, Reference Example]

The same method as Example 1 was performed, except that 5 parts of the thermoplastic polymer (Al-3) and 95 parts of the acrylic-based rubber-containing polymer (B) were used.

The total light transmittance of the acrylic resin film was 92%, and as the adhesion to EVA, the peeling strength thereof was 25 N/15 mm, that means good adhesion.

The results are listed in Table 3.

[Example 7, Reference Example]

The same method as Example 1 was performed, except that 10 parts of the thermoplastic polymer (A1-3) and 90 parts of the acrylic-based rubber-containing polymer (B) were used.

The total light transmittance of the acrylic resin film was 90%, and as the adhesion to EVA, the peeling strength thereof was 26 N/15 mm, that means good adhesion.

The results are listed in Table 3.

[Example 8, Reference Example]

The same method as Example 1 was performed, except that 3 parts of the thermoplastic polymer (A1-4) and 97 parts of the acrylic-based rubber-containing polymer (B) were used.

The total light transmittance of the acrylic resin film was 92%, and as the adhesion to EVA, the peeling strength thereof was 24 N/15 mm, that means good adhesion.

The results are listed in Table 3.

[Example 9, Reference Example]

The same method as Example 1 was performed, except that 5 parts of the thermoplastic polymer (A1-4) and 95 parts of the acrylic-based rubber-containing polymer (B) were used.

The total light transmittance of the acrylic resin film was 91%, and as the adhesion to EVA, the peeling strength thereof was 30 N/15 mm, that means good adhesion.

The results are listed in Table 3.

[Example 10, Reference Example]

The pellet of the acrylic resin composition used in Example 9 and polyvinylidene fluoride (prepared by ARKEMA K.K., Trade Name: KYNAR720) as a fluororesin (D) were dried in a dehumidifying drier at 80°C for a day.

The dried pellet of the acrylic resin composition was supplied to a single screw extruder having 40 mm φ and a cylinder temperature of 230 to 260°C and the dried fluororesin (D) was supplied to a single screw extruder having 30 mm φ and a cylinder temperature of 230 to 250°C, and then, each of them was individually melted and plasticized. Then, a laminated film including two layers of the acrylic resin layer and fluororesin layer was obtained by supplying the melted and plasticized pellet and fluororesin (D) to a multi-manifold die that was heated to 250°C, and then, conveying the film to make the acrylic resin side to come in contact with a first cooling roll at 80°C and a second cooling roll at 75°C.

As a result of measuring the thickness by observing the cross section of the laminated film, the thickness of the acrylic resin layer was about 125 μm, the thickness of the fluororesin layer was about 5 μm, and the total thickness thereof was about 130 μm.

The optical properties and adhesion of the obtained laminated film were measured in the same method as Example 1.

The total light transmittance of the laminated film was 91%, and as the adhesion to EVA, the peeling strength thereof was 30 N/15 mm, that means good adhesion.

Furthermore, the adhesion was evaluated by laminating EVA and the acrylic resin layer of the laminated film.

[Example 11, Reference Example]

The same method as Example 1 was performed, except that 10 parts of the thermoplastic polymer (A1-4) and 90 parts of the acrylic-based rubber-containing polymer (B) were used.

The total light transmittance of the acrylic resin film was 90%, and as the adhesion to EVA, the peeling strength thereof was 27 N/15 mm, that means good adhesion.

The results are listed in Table 3.

[Example 12, Reference Example]

The same method as Example 1 was performed, except that 7.5 parts of the thermoplastic polymer (A1-5) and 92.5 parts of the acrylic-based rubber-containing polymer (B) were used.

The total light transmittance of the acrylic resin film was 92%, and as the adhesion to EVA, the peeling strength thereof was 18 N/15 mm, that means good adhesion.

The results are listed in Table 3.

[Example 13, Reference Example]

The same method as Example 1 was performed, except that 15 parts of the thermoplastic polymer (Al-5) and 85 parts of the acrylic-based rubber-containing polymer (B) were used.

The total light transmittance of the acrylic resin film was 92%, and as the adhesion to EVA, the peeling strength thereof was 20 N/15 mm, that means good adhesion.

The results are listed in Table 3.

[Example 14, Reference Example]

The same method as Example 1 was performed, except that 20 parts of the thermoplastic polymer (A1-6) and 80 parts of the acrylic-based rubber-containing polymer (B) were used.

The total light transmittance of the acrylic resin film was 92%, and as the adhesion to EVA, the peeling strength thereof was 18 N/15 mm, that means good adhesion.
The results are listed in Table 3.

[Example 15, Reference Example]

The same method as Example 1 was performed, except that 20 parts of the thermoplastic polymer (A1-7) and 80 parts of the acrylic-based rubber-containing polymer (B) were used.
The total light transmittance of the acrylic resin film was 92%, and as the adhesion to EVA, the peeling strength thereof was 10 N/15 mm, that means sufficient adhesion.
The results are listed in Table 3.

[Comparative Example 1]

The same method as Example 1 was performed, except that the acrylic-based rubber-containing polymer (B) was only used.
The total light transmittance of the acrylic resin film was 92%, and as the adhesion to EVA, the peeling strength thereof was 8 N/15 mm, that means insufficient adhesion.
The results are listed in Table 3.

[Table 3] (*Reference Examples)

Table 3

| | | | | | Example 1* | Example 2* | Example 3* | Example 4* | Example 5* | Example 6* | Example 7* | Example 8* | Example 9* | Example 10* | Example 11* | Example 12* | Example 13* | Example 14* | Example 15* | Comparative Example 1 |
|---|---|---|---|---|---|---|---|---|---|---|---|---|---|---|---|---|---|---|---|---|
| Acrylic resin composition | Acrylic resin | Thermoplastic polymer (A1) [Content of i-BMA] | A1-1 [98% by mass] Mw 30,000 | | 5 | 10 | - | - | - | - | - | - | - | | | - | | - | | - |
| | | | A1-2 [100% by mass] Mw 50,000 | | - | - | 5 | 10 | - | - | - | - | - | - | - | - | - | - | - | - |
| | | | A1-3 [100% by mass] Mw 160,000 | | - | - | - | - | 3 | 5 | 10 | - | - | - | - | - | - | - | - | - |
| | | | A1-4 [98% by mass] Mw 2,500,000 | | - | - | | | - | - | - | 3 | 5 | 5 | 10 | - | - | - | - | - |
| | | | A1-5 [75% by mass] Mw 220,000 | | - | - | - | - | - | - | - | - | - | - | - | 7.5 | 15 | - | - | - |
| | | | A1-6 [50% by mass] Mw 220,000 | | - | - | - | - | - | - | - | - | - | - | - | - | - | 20 | - | - |
| | | | A1-7 [25% by mass] Mw 210,000 | | - | - | - | - | - | - | - | - | - | - | - | - | - | - | 20 | - |
| | | Acrylic-based rubber-containing polymer (B) | | | 95 | 90 | 95 | 90 | 97 | 95 | 90 | 97 | 95 | 95 | 90 | 92.5 | 85 | 80 | 80 | 100 |
| | Various combining agents | | LA-31 | | 1.9 | 1.9 | 1.9 | 1.9 | 1.9 | 1.9 | 1.9 | 1.9 | 1.9 | 1.9 | 1.9 | 1.9 | 1.9 | 1.9 | 1.9 | 1.9 |
| | | | LA-57 | | 0.3 | 0.3 | 0.3 | 0.3 | 0.3 | 0.3 | 0.3 | 0.3 | 0.3 | 0.3 | 0.3 | 0.3 | 0.3 | 0.3 | 0.3 | 0.3 |
| | | | Irganox 1076 | | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 |
| | Fluororesin layer (thickness μm) | | | | - | - | - | - | - | - | - | - | - | 5 | | - | - | - | | - |
| Evaluation items | Optical properties | | Haze (%) | | 1.0 | 25.3 | 2.1 | 22.4 | 0.5 | 1.4 | 8.0 | 2.1 | 4.2 | 6.5 | 20.5 | 0.7 | 1.6 | 0.5 | 0.5 | 0.6 |
| | | | Total light transmittance (%) | | 92 | 89 | 91 | 89 | 92 | 92 | 90 | 92 | 91 | 91 | 90 | 92 | 92 | 92 | 92 | 92 |
| | | Adhesion to EVA [Peeling strength (N/15 mm)] | | | 15 | 15 | 15 | 15 | 22 | 25 | 26 | 24 | 30 | 30 | 27 | 18 | 20 | 18 | 10 | 8 |

[Example 16]

LA-31 (Trade Name) that is a benzotriazole-based ultraviolet ray absorbent prepared by ADEKA CORPORATION as an ultraviolet ray absorbent, LA-57 (Trade Name) that is hindered amine-based photo-stabilizer prepared by ADEKA CORPORATION as photo-stabilizer, and Irganox 1076 (Trade Name) that is a hindered phenol-based oxidation inhibitor prepared by BASF as an antioxidant were added in the combination amounts listed in Table 2 to 100 parts of the rubber-containing polymer (A2-1) obtained from Preparation Example 8, and the mixture thus obtained was mixed using a Henschel mixer to obtain an acrylic resin composition.

The acrylic resin composition was supplied to a degasifying twin-screw kneading extruder (manufactured by Toshiba Machine Co., Ltd., Trade Name: TEM-35B) that was heated to 230°C, and then, was blended to obtain a pellet material of the acrylic resin composition.

By using the pellet of the acrylic resin composition thus obtained, a film was formed under the conditions of a cylinder temperature of 200°C to 240°C, a T-die temperature of 250°C, and a cooling roll temperature of 80°C using a non-vented screw-type extruder (L/D = 26) having a diameter of 40 mm φ installed with a T-die having a width of 300 mm, the obtained acrylic resin film was wound on a paper pipe using a winding machine to obtain the rolled article of the acrylic resin film having a thickness of 125 μm.

As a result of measuring optical properties of the obtained acrylic resin film, it was confirmed that the total light transmittance was 93%, which means excellent light transmittance.

In addition, as a result of confirming the adhesion between the acrylic resin film and EVA, it was confirmed that the peeling strength was 26 N/15 mm, which means good adhesion.

The results are listed in Table 4.

[Example 17]

The same method as Example 15 was performed, except that 100 parts of the rubber-containing polymer (A2-2) was used.

As a result of measuring an optical property of the obtained acrylic resin film, it was confirmed that the total light transmittance was 93%, which means excellent light transmittance.

In addition, as a result of confirming the adhesion between the acrylic resin film and EVA, the peeling strength thereof was 24 N/15 mm, which means good adhesion.

The results are listed in Table 4.

[Example 18]

By using the acrylic resin composition of Example 17 and polyvinylidene fluoride (prepared by ARKEMA K.K., Trade Name: KYNAR720) as a fluororesin (D), the laminated film having about 125 μm of an acrylic resin layer, about 5 μm of a fluororesin layer, and about 130 μm of the total thickness was obtained in the same method as Example 10.

As a result of measuring an optical property of the obtained laminated film, it was confirmed that the total light transmittance was 93%, which means excellent light transmittance.

In addition, as a result of confirming the adhesion between the acrylic resin film and EVA, the peeling strength thereof was 24 N/15 mm, which means good adhesion.

Furthermore, the adhesion was evaluated by laminating EVA and the acrylic resin layer of the laminated film.

The results are listed in Table 4.

[Example 19]

The same method as Example 15 was performed, except that 100 parts of the rubber-containing polymer (A2-3) was used.

As a result of measuring an optical property of the obtained acrylic resin film, it was confirmed that the total light transmittance was 93%, which means excellent light transmittance.

In addition, as a result of confirming the adhesion between the acrylic resin film and EVA, the peeling strength thereof was 17 N/15 mm, which means good adhesion.

The results are listed in Table 4.

[Comparative Example 2]

LA-31 (Trade Name) that is a benzotriazole-based ultraviolet ray absorbent prepared by ADEKA CORPORATION as an ultraviolet ray absorbent, LA-57 (Trade Name) that is hindered amine-based photo-stabilizer prepared by ADEKA CORPORATION as photo-stabilizer, and Irganox 1076 (Trade Name) that is a hindered phenol-based oxidation inhibitor prepared by BASF as an antioxidant were added in the combination amounts listed in Table 4 to 100 parts of the rubber-containing polymer (A2-4), and the mixture thus obtained was mixed using a Henschel mixer to obtain an acrylic resin composition.

The acrylic resin composition was supplied to a degasifying twin-screw kneading extruder (manufactured by Toshiba Machine Co., Ltd., Trade Name: TEM-35B) that was heated to 230°C, and then, was blended to obtain a pellet material of the acrylic resin composition.

By using the obtained pellet of the acrylic resin composition, a film was formed under the conditions of a cylinder temperature of 200°C to 240°C, a T-die temperature of 250°C, and a cooling roll temperature of 80°C using a non-vented screw-type extruder (L/D = 26) having a diameter of 40 mm φ installed with a T-die having a width of 300 mm. However, it was difficult to prepare the thin film in a film shape, and then, it was impossible to perform the subsequent evaluations.

The results are listed in Table 4.

[Table 4]

| Table 4 | | | | Example 16 | Example 17 | Example 18 | Example 19 | Comparative Example 2 |
|---|---|---|---|---|---|---|---|---|
| Acrylic resin composition | Acrylic resin | Rubber-containing polymer (A2) | A2-1 | 100 | - | - | - | - |
| | | | A2-2 | - | 100 | 100 | - | - |
| | | | A2-3 | - | - | - | 100 | - |
| | | | A2-4 | - | - | - | - | 100 |
| | Various combining agents | LA-31 | | 1.9 | 1.9 | 1.9 | 1.9 | 1.9 |
| | | LA-57 | | 0.3 | 0.3 | 0.3 | 0.3 | 0.3 |
| | | Irganox 1076 | | 0.1 | 0.1 | 0.1 | 0.1 | 0.1 |
| Fluororesin layer (thickness, $\mu$m) | | | | - | - | 5 | - | - |
| Evaluation items | Film-forming property | | | ○ | ○ | ○ | ○ | × |
| | Optical properties | Haze (%) | | 0.6 | 0.6 | 5.0 | 0.4 | Impossible evaluation |
| | | Total light transmittance (%) | | 93 | 93 | 93 | 93 | Impossible evaluation |
| | Adhesion to ethylene-vinyl acetate copolymer [Peeling strength (N/15 mm)] | | | 26 | 24 | 25 | 17 | Impossible evaluation |

EP 2 910 582 B1

28

(Preparation of film laminate)

[Example 20 Reference Example]

A polypropylene resin (manufactured by Japan Polypropylene Corporation, Trade Name "Novatec PP FY4") as a polyolefin-based resin was dried at 80°C for 12 hours, and then, with the dried resin, a film was formed using a single twin extruder (L/D = 30, manufactured by GM ENGINEERING, Inc.) having a T-die under the conditions of 20 rpm of a screw revolution number, 200°C of a cylinder temperature, and 210°C of a T-die temperature to have 500 $\mu$m of the film thickness and 10 cm of the film width.

A heat-pressing operation was performed by laminating the film constituted of the polypropylene and the acrylic resin film prepared in Example 8, inserting the films laminated between the stainless plates having a polished mirror surface, heat-pressing at the temperature conditions of 180°C on the side of the acrylic resin film and 210°C on the side of the polypropylene resin film at 2 MPa for 5 minutes and then at 4 MPa for 5 minutes, and finally, decompressed-cooling the film at 25°C and 4 MPa for 5 minutes.

After cooling, as a result of peeling the stainless plate, the laminate laminated with the acrylic resin film and the polypropylene resin film was obtained.

[Example 21]

The same method as Example 20 was performed except that the acrylic resin film prepared from Example 16 was used.

After cooling, as a result of peeling the stainless plate, the laminate laminated with the acrylic resin film and the polypropylene resin film was obtained.

[Comparative Example 3]

The same method as Example 20 was performed except that the acrylic resin film prepared from Comparative Example 1 was used.

After cooling, as a result of peeling the stainless plate, the acrylic resin film was adhered to the stainless plate, and thus, it was impossible to laminate the polypropylene resin and the acrylic resin.

(Manufacturing of solar cell module)

[Example 22 Reference Example]

A releasing sheet, the acrylic resin film prepared in Example 2, an EVA sheet (manufactured by C. I. KASEI CO., LTD., Trade Name "CIKcap(R) FLCE-51", a thickness of 450 $\mu$m) as a thermosetting encapsulant, a monocrystalline silicon wafer (manufactured by JINTEC CORPORATION, a polycrystalline silicon) as a solar cell, an encapsulate (as described above), a polyethylene terephthalate film laminate (manufactured by MA PACKAGING Co., Ltd.) as a support, and a releasing sheet were laminated from above on a vacuum laminator having the heaters on the top and bottom thereof (manufactured by NPC Incorporated, Type: LM-50 $\times$ 50-S type), and then, the obtained one was installed in a chamber of the vacuum laminator that was heated to 150°C.

After installing, the inside of the chamber was subjected to a vacuum for 10 minutes. After confirming the sufficient vacuum, the heat-pressing was performed under a vacuum atmospheric pressure at 150°C for 30 minutes to obtain a laminate. The peeling sheet was removed from the obtained laminate to obtain a solar cell module using the acrylic resin film of the invention.

The obtained solar cell module was capable to generate electricity without any problems.

[Example 23]

The same method as Example 20 was performed except that the acrylic resin film prepared from Example 16 was used.

The obtained solar cell module was capable to generate electricity without any problems.

INDUSTRIAL APPLICABILITY

As described above, according to the invention, an acrylic resin film having excellent light transmittance and also excellent adhesion to a polyolefin-based resin, a laminate thereof, and a solar cell module using the film can be provided.

**Claims**

1. An acrylic resin film comprising a polymer (A) obtained by polymerizing a monomer component including i-butyl methacrylate, wherein the polymer (A) is a rubber-containing polymer (A2) being obtained by polymerizing a monomer component including 10 to 100% by mass of i-butyl methacrylate in the presence of an acrylic-based rubber polymer (A2a), and also, satisfying the following contents,

   • 15 to 60% by mass of an acrylic-based rubber polymer (A2a)
   • 85 to 40% by mass of a polymer (A2b) obtained by polymerizing a monomer component including 10 to 100% by mass of i-butyl methacrylate under the condition that the total amount of A2a and A2b is 100% by mass, wherein the acrylic-based rubber polymer (A2a) is a polymer obtained by polymerizing the following monomer components:
   <Monomer component>

   1. 40 to 99.9% by mass of alkyl acrylate
   2. 0 to 59.9% by mass of alkyl methacrylate
   3. 0 to 49.9% by mass of other monomers having a double bond capable of being copolymerized with alkyl acrylate and/or alkyl methacrylate
   4. 0.1 to 10% by mass of the multifunctional monomer having two or more double bonds in one molecule, which are capable of being copolymerized with the monomers of 1 to 3
   5. 50 to 99.9% by mass of the total amount of alkyl acrylate and alkyl methacrylate, and wherein the total amount of the above 1 to 4 is 100% by mass.

2. The acrylic resin film according to claim 1, wherein a thickness of the acrylic resin film is 10 to 500 $\mu$m.

3. The acrylic resin film according to claim 1 or 2, wherein a peeling strength is 10 N/15 mm or more when the following specimen is measured under the following conditions:

   <Specimen>

   First layer: Acrylic resin film
   Second layer: Ethylene-vinyl acetate copolymer film
   Third layer: Support film
   The above films in order are laminated, and then, heat-pressed under a vacuum atmospheric pressure at 135°C for 15 minutes using a vacuum heat-pressing device to obtain a laminate.

   • The laminate is cut to be 15 mm $\times$ 150 mm.

   <Test conditions>
   The first layer of the specimen only is chucked, and the second layer and third layer are together chucked, and then, when peeling the specimen off, the peeling strength is measured.

   • Peeling angle: 180°
   • Peeling rate: 100 mm/min

4. The acrylic resin film according to any one of claims 1 to 3, the acrylic resin film further comprising a fluororesin (D).

5. The acrylic resin film according to claim 4, the acrylic resin film comprising 10 to 95% by mass of the polymer (A) and 90 to 5% by mass of the fluororesin (D) (the total amount of the polymer (A) and the fluororesin (D) is 100% by mass).

6. The acrylic resin film according to any one of claims 1 to 5, the acrylic resin film being formed by laminating a fluororesin layer including a fluororesin (D) at least on one side thereof.

7. A laminated molded body having at least two layers, the laminated molded body being laminated with the acrylic resin film according to any one of claims 1 to 6 and a thermoplastic resin sheet and/or a thermosetting resin sheet.

8. The laminated molded body of claim 7, wherein the thermoplastic resin sheet and/or the thermosetting resin sheet are an ethylene-vinyl acetate copolymer.

9. The acrylic resin film according to any one of claims 1 to 6, the acrylic resin film being used as a surface protective material for a solar cell.

10. A solar cell module using the acrylic resin film according to any one of claims 1 to 6, and 9.

11. A polymer being a rubber-containing polymer obtained by polymerizing a monomer component including 10 to 100% by mass of i-butyl methacrylate in the presence of an acrylic-based rubber polymer (A2a), and also, satisfying the following contents:

• The ratio of an acrylic-based rubber polymer (A2a) is 15 to 60% by mass.
• The ratio of a polymer (A2b) obtained by polymerizing a monomer component including 10 to 100% by mass of i-butyl methacrylate is 85 to 40% by mass (under the condition that the total amount of A2a and A2b is 100% by mass), wherein the acrylic-based rubber polymer (A2a) is obtained by polymerizing the following monomer component:
<Monomer component>

1. 40 to 99.9% by mass of alkyl acrylate
2. 0 to 59.9% by mass of alkyl methacrylate
3. 0 to 49.9% by mass of other monomers having a double bond capable of being copolymerized with alkyl acrylate and/or alkyl methacrylate
4. 0.1 to 10% by mass of multifunctional monomer having two or more double bonds in one molecule, which are capable of being copolymerized with the monomers disclosed in 1 to 3
5. 50 to 99.9% by mass of the total amount of alkyl acrylate and alkyl methacrylate, and wherein the total amount of the above 1 to 4 is 100% by mass.

**Patentansprüche**

1. Acrylharzfilm, umfassend ein Polymer (A), erhalten durch Polymerisieren einer Monomerkomponente einschließlich i-Butylmethacrylat, wobei das Polymer (A) ein kautschukhaltiges Polymer (A2) ist, das erhalten wird durch Polymerisieren einer Monomerkomponente einschließlich 10 bis 100 Masse-% i-Butylmethacrylat in Gegenwart eines acrylbasierten Kautschukpolymers (A2a), und das ebenso die folgenden Gehalte aufweist:

• 15 bis 60 Masse-% eines acrylbasierten Kautschukpolymers (A2a)
• 85 bis 40 Masse-% eines Polymers (A2b), erhalten durch Polymerisieren einer Monomerkomponente einschließlich 10 bis 100 Masse-% i-Butylmethacrylat unter der Bedingung, dass die Gesamtmenge an A2a und A2b 100 Masse-% beträgt, wobei das acrylbasierte Kautschukpolymer (A2a) ein Polymer ist, erhalten durch Polymerisieren der folgenden Monomerkomponenten:
<Monomerkomponente>

1. 40 bis 99,9 Masse-% Alkylacrylat
2. 0 bis 59,9 Masse-% Alkylmethacrylat
3. 0 bis 49,9 Masse-% anderer Monomere mit einer Doppelbindung, die in der Lage ist, mit einem Alkylacrylat und/oder Alkylmethacrylat copolymerisiert zu werden,
4. 0,1 bis 10 Masse-% des multifunktionellen Monomers mit zwei oder mehr Doppelbindungen in einem Molekül, welche in der Lage sind, mit den Monomeren von 1 bis 3 copolymerisiert zu werden
5. 50 bis 99,9 Masse-% der Gesamtmenge an Alkylacrylat und Alkylmethacrylat, und wobei die Gesamtmenge der obigen 1 bis 4 100 Masse-% beträgt.

2. Acrylharzfilm nach Anspruch 1, wobei eine Dicke des Acrylharzfilms 10 bis 500 $\mu$m beträgt.

3. Acrylharzfilm nach Anspruch 1 oder 2, wobei eine Abschälfestigkeit 10 N/15 mm oder mehr beträgt, wenn der folgende Prüfkörper unter den folgenden Bedingungen gemessen wird:

<Prüfkörper>

Erste Schicht: Acrylharzfilm
Zweite Schicht: Ethylen-Vinylacetat-Copolymerfilm
Dritte Schicht: Trägerfilm
Die obigen Filme werden der Reihe nach laminiert und dann unter einem Vakuum-Atmosphärendruck bei 135 °C während 15 Minuten unter Verwendung einer Vakuum-Wärmepressevorrichtung wärmeverpresst, um ein Laminat zu erhalten;

• Das Laminat wird auf 15 mm x 150 mm geschnitten;

<Prüfbedingungen>
Die erste Schicht des Prüfkörpers wird alleine eingespannt, und die zweite Schicht und dritte Schicht werden zusammen eingespannt, und dann, wenn der Prüfkörper abgeschält wird, wird die Abschälfestigkeit gemessen;

• Abschälwinkel: 180°
• Abschälgeschwindigkeit: 100 mm/min

4. Acrylharzfilm nach irgendeinem der Ansprüche 1 bis 3, wobei der Acrylharzfilm weiterhin ein Fluoroharz (D) umfasst.

5. Acrylharzfilm nach Anspruch 4, wobei der Acrylharzfilm 10 bis 95 Masse-% des Polymers (A) und 90 bis 5 Masse-% des Fluoroharzes (D) umfasst (die Gesamtmenge des Polymers (A) und des Fluoroharzes (D) beträgt 100 Masse-%).

6. Acrylharzfilm nach irgendeinem der Ansprüche 1 bis 5, wobei der Acrylharzfilm gebildet wird durch Laminieren einer Fluoroharzschicht einschließlich einem Fluoroharz (D) auf mindestens eine Seite hiervon.

7. Laminierter Formkörper mit mindestens zwei Schichten, wobei der laminierte Formkörper mit dem Acrylharzfilm nach irgendeinem der Ansprüche 1 bis 6 und einer thermoplastischen Harzfolie und/oder einer wärmehärtenden Harzfolie laminiert ist.

8. Laminierter Formkörper nach Anspruch 7, wobei die thermoplastische Harzfolie und/oder die wärmehärtende Harzfolie ein Ethylen-Vinylacetat-Copolymer sind.

9. Acrylharzfilm nach irgendeinem der Ansprüche 1 bis 6, wobei der Acrylharzfilm als ein Oberflächenschutzmaterial für eine Solarzelle verwendet wird.

10. Solarzellenmodul, welcher den Acrylharzfilm nach irgendeinem der Ansprüche 1 bis 6 und 9 verwendet.

11. Polymer, das ein kautschukhaltiges Polymer ist, erhalten durch Polymerisieren einer Monomerkomponente einschließlich 10 bis 100 Masse-% i-Butylmethacrylat in Gegenwart eines acrylbasierten Kautschukpolymers (A2a), und das ebenso die folgenden Gehalte aufweist:

• der Anteil eines acrylbasierten Kautschukpolymers (A2a) beträgt 15 bis 60 Masse-%;
• der Anteil eines Polymers (A2b), erhalten durch Polymerisieren einer Monomerkomponente einschließlich 10 bis 100 Masse-% i-Butylmethacrylat beträgt 85 bis 40 Masse-% (unter der Bedingung, dass die Gesamtmenge an A2a und A2b 100 Masse-% beträgt), wobei das acrylbasierte Kautschukpolymer (A2a) erhalten wird durch Polymerisieren der folgenden Monomerkomponente:
<Monomerkomponente>

1. 40 bis 99,9 Masse-% Alkylacrylat
2. 0 bis 59,9 Masse-% Alkylmethacrylat
3. 0 bis 49,9 Masse-% anderer Monomere mit einer Doppelbindung, die in der Lage ist, mit einem Alkylacrylat und/oder Alkylmethacrylat copolymerisiert zu werden,
4. 0,1 bis 10 Masse-% multifunktionelles Monomer mit zwei oder mehr Doppelbindungen in einem Molekül, welche in der Lage sind, mit den in 1 bis 3 beschriebenen Monomeren copolymerisiert zu werden;
5. 50 bis 99,9 Masse-% der Gesamtmenge an Alkylacrylat und Alkylmethacrylat, und wobei die Gesamtmenge der obigen 1 bis 4 100 Masse-% beträgt.

## EP 2 910 582 B1

**Revendications**

1. Un film de résine acrylique comprenant un polymère (A) obtenu par polymérisation d'un composant monomère comprenant du méthacrylate d'i-butyle, dans lequel contenant du caoutchouc (A2) qui est obtenu par polymérisation d'un composant monomère comprenant 10 à 100 % en masse de méthacrylate d'i-butyle en la présence d'un polymère de caoutchouc à base acrylique (A2), et aussi satisfaisant les contenus suivants,

   • 15 à 60 % en masse d'un polymère de caoutchouc à base acrylique (A2a)
   • 85 à 40 % en masse d'un polymère (A2b) obtenu par polymérisation d'un composant monomère comprenant de 10 à 100 % en masse de méthacrylate d'i-butyle sous la condition que la quantité totale de A2a et A2b correspond à 100 % en masse, dans lequel le polymère de caoutchouc à base acrylique (A2) est un polymère obtenu par polymérisation des composants monomère suivant :
   <composant monomère>

   1. 40 à 99,9 % en masse d'acrylate d'alkyle
   2. 0 à 59,9 % en masse d'un méthacrylate d'alkyle
   3. 0 à 49,9 % en masse d'autres monomères ayant une double liaison capable d'être copolymèrisés avec de l'acrylate d'alkyle et / ou du méthacrylate d'alkyle
   4. 0,1 à 10 % en masse d'un monomère multifonctionnel ayant deux ou plusieurs double liaisons dans une molécule, qui sont capables d'être copolymèrisés avec les monomères de 1 à 3
   5. 50 à 99,9 % en masse de la quantité totale d'acrylate d'alkyle et de méthacrylate d'alkyle, dans lequel la quantité totale des 1 à 4 ci-hauts correspond à 100 % en masse.

2. Le film de résine acrylique selon la revendication 1, dans lequel une épaisseur du film de résine acrylique est de 10 à 500 μm.

3. Le film de résine acrylique selon la revendication 1 ou 2, dans lequel la résistance au pelage est de 10 N / 15 mm ou plus lorsque l'échantillon suivant est mesuré dans les conditions suivantes:

   <Spécimen>

   Première couche: film de résine acrylique
   Deuxième couche: film de copolymère d'éthylène et d'acétate de vinyle
   Troisième couche: film de support
   Les films ci-dessus dans l'ordre sont laminés, puis pressés à chaud sous pression atmosphérique à 135 °C pendant 15 minutes à l'aide d'un dispositif de pressage à chaud pour obtenir un stratifié.

   • Le stratifié est coupé pour mesurer 15 mm × 150 mm.

   <Conditions de test>
   La première couche de l'éprouvette seulement est collée et les deuxième et troisième couches sont reliées ensemble, puis, lors du pelage de l'éprouvette, la résistance au pelage est mesurée.

   • Angle de pelage: 180 °
   • Taux de pelage: 100 mm / min

4. Le film de résine acrylique selon l'une quelconque des revendications 1 à 3, dans lequel le film de résine acrylique en outre comprend une résine fluorée (D).

5. Le film de résine acrylique selon la revendication 4, le film de résine acrylique comprenant de 10 à 95 % en masse du polymère (A) et 90 à 5 % en masse de la résine fluorée (D) (la quantité totale du polymère (A) et de la résine fluorée (D) correspondant à 100 % en masse).

6. Le film de résine acrylique selon l'une quelconque des revendications 1 à 5, de film de résine acrylique étant formé en stratifiant une couche de résine fluorée comprenant une résine fluorée (D) au moins sur un côté de celle-ci.

7. Un corps moulu stratifié ayant au moins deux couches, le corps moulu stratifié étant stratifié avec le film de résine acrylique selon l'une quelconque des revendications 1 à 6 et une feuille de résine thermoplastique et / ou une feuille de résine thermodurcissable.

8. Le corps moulu stratifié selon la revendication 7, dans lequel la feuille de résine thermoplastique et / ou la feuille de résine thermodurcissable sont un copolymère d'acétate de vinyle et d'éthylène.

9. Le film de résine acrylique selon l'une quelconque des revendications 1 à 6, le film de résine acrylique étant utilisé en tant que matériau de protection de surface pour une cellule solaire.

10. Un module de cellules solaires utilisant le film de résine acrylique selon l'une quelconque des revendications 1 à 6, et 9.

11. Un polymère qui est un polymère contenant du caoutchouc obtenu par polymérisation d'un composant monomère comprenant de 10 à 100 % en masse de méthacrylate d'i-butyle en la présence d'un polymère de caoutchouc à base acrylique (A2a), et satisfaisant également aux teneurs suivantes:

   • Le pourcentage d'un polymère de caoutchouc à base d'acrylique (A2a) est de 15 à 60% en masse.
   • Le pourcentage d'un polymère (A2b) obtenu en polymérisant un composant monomère comprenant 10 à 100% en masse de méthacrylate d'i-butyle est de 85 à 40 % en masse (à condition que la quantité totale de A2a et de A2b soit de 100 % en masse), dans lequel le polymère de caoutchouc à base acrylique (A2a) est obtenu par polymérisation du composant monomère suivant:
   <composant monomère>

   1. 40 à 99,9% en masse d'acrylate d'alkyle
   2. 0 à 59,9% en masse de méthacrylate d'alkyle
   3. 0 à 49,9% en masse d'autres monomères ayant une double liaison capable d'être copolymérisée avec un acrylate d'alkyle et / ou un méthacrylate d'alkyle
   4. 0,1 à 10% en masse de monomère multifonctionnel possédant deux ou plusieurs doubles liaisons dans une molécule, pouvant être copolymérisé avec les monomères décrits aux paragraphes 1 à 3
   5. 50 à 99,9% en masse de la quantité totale d'acrylate d'alkyle et de méthacrylate d'alkyle lorsque la quantité totale de 1 à 4 ci-dessus est de 100% en masse.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2012066848 A1
- US 2008017241 A1
- EP 1065731 A
- JP 2004227843 A

### Non-patent literature cited in the description

- **J. BRANDRUP.** Interscience. *Polymer HandBook,* 1989